# EUROPEAN PATENT SPECIFICATION

(11) **EP 4 398 096 B1**
(45) Date of publication and mention of the grant of the patent: **06.05.2026**
(21) Application number: 23777673.7
(22) Date of filing: 15.02.2023
(51) Int. Cl.: H03M 7/30, G06F 9/30, H03M 1/66

(54) **VECTOR DATA COMPRESSION METHOD, VECTOR DATA DECOMPRESSION METHOD, APPARATUS, AND DEVICE**
VEKTORDATENKOMPRIMIERUNGSVERFAHREN, VEKTORDATENDEKOMPRIMIERUNGSVERFAHREN, -VORRICHTUNG UND -VORRICHTUNG
PROCÉDÉ DE COMPRESSION DE DONNÉES VECTORIELLES, PROCÉDÉ DE DÉCOMPRESSION DE DONNÉES VECTORIELLES, APPAREIL ET DISPOSITIF

(30) Priority: 28.03.2022 CN 202210312611
(43) Date of publication of application: 10.07.2024
(73) Proprietor: Tencent Technology (Shenzhen) Company Limited, Shenzhen, Guangdong, 518057 (CN)
(72) Inventor: REN, Zimu, Shenzhen, Guangdong 518057 (CN); LI, Dongsheng, Shenzhen, Guangdong 518057 (CN)
(74) Representative: Nederlandsch Octrooibureau
(86) International application number: PCT/CN2023/076224
(87) International publication number: WO 2023/185294

(56) References cited:
- CN-A- 103 499 787
- CN-A- 104 866 278
- CN-A- 106 575 216
- CN-A- 114 416 180
- US-A1- 2012 076 401
- US-A1- 2016 085 547
- US-A1- 2016 188 333
- US-A1- 2018 309 461
- US-A1- 2020 065 097

## Description

### RELATED APPLICATION

This application claims to Chinese Patent Application No. 202210312611.4, entitled "METHOD AND APPARATUS FOR COMPRESSING VECTOR DATA, METHOD AND APPARATUS FOR DECOMPRESSING VECTOR DATA, AND DEVICE" filed on March 28, 2022.

### FIELD OF THE TECHNOLOGY

This application relates to the field of data processing technologies, and in particular, to a method and an apparatus for compressing vector data, a method and an apparatus for decompressing vector data, and a device.

### BACKGROUND OF THE DISCLOSURE

Currently, some mainstream artificial intelligence (AI) processors in the industry are designed with a data compression instruction, which may be used for accelerating the inference and training efficiency of the AI processors. An implementation of the data compression instruction has significant impact on the AI processors.

In related art, the data compression instruction is implemented through direct compression of vector data by using a set of multiplexers (MUX). For example, during compression of vector data with 16 elements, 15 MUXes need to be arranged. The 15 MUXes are successively 16-1 MUX, 15-1 MUX, ..., and 2-1 MUX in ascending order of bits. US 2018/0309461Al refers to "apparatus and method for vector compression".

### SUMMARY

Embodiments of this application provide a method and an apparatus for compressing vector data, a method and an apparatus for decompressing vector data, and a device, which can reduce a congestion level of wire required for implementing a data compression instruction in an AI processor, and reduce an area of the AI processor. The technical solutions may include the following contents.

According to an aspect of the embodiments of this application, a method for compressing vector data is provided, the method being executed by a processor, the processor including a source vector register, n sets of multiplexers, a data merging apparatus, and a target vector register, n being an integer greater than 1.

The method is defined in appended set of claims.

According to an aspect of the embodiments of this application, a method for decompressing vector data is provided, the method being executed by a processor, the processor including a target vector register, a data splitting apparatus, and n sets of multiplexers, n being an integer greater than 1.

The method is defined in appended set of claims.

According to an aspect of the embodiments of this application, a processor is provided, the processor including a source vector register, n sets of multiplexers, a data merging apparatus, and a target vector register, each set of multiplexers including at least two multiplexers, and n being an integer greater than 1;
the source vector register including n sets of output ports, the n sets of output ports being respectively connected to input ports of the n sets of multiplexers;
output ports of the n sets of multiplexers being connected to an input port of the data merging apparatus; and
an input port of the target vector register being connected to an output port of the data merging apparatus.

According to an aspect of the embodiments of this application, a processor is provided, the processor including a target vector register, a data splitting apparatus, and n sets of multiplexers, each set of multiplexers including at least two multiplexers, and n being an integer greater than 1;
an output port of the target vector register being connected to an input port of the data splitting apparatus; and
an output port of the data splitting apparatus being connected to input ports of the n sets of multiplexers.

According to an aspect of the embodiments of this application, a computer device is provided, the computer device including a processor and a memory, the memory storing at least one instruction, at least one program, a code set, or an instruction set, the at least one instruction, the at least one program, the code set, or the instruction set being loaded and executed by the processor to cause the computer device to implement the foregoing method for compressing vector data, or implement the foregoing method for decompressing vector data.

According to an aspect of the embodiments of this application, a non-volatile computer-readable storage medium is provided, the non-volatile computer-readable storage medium storing at least one instruction, at least one program, a code set, or an instruction set, the at least one instruction, the at least one program, the code set, or the instruction set being loaded and executed by a processor to cause a computer to implement the foregoing method for compressing vector data, or implement the foregoing method for decompressing vector data.

According to an aspect of the embodiments of this application, a computer program product or a computer program is provided, the computer program product or the computer program including computer instructions, the computer instructions being stored in a non-volatile computer-readable storage medium. A processor of a computer device reads the computer instructions from the non-volatile computer-readable storage medium, and executes the computer instructions to cause the computer device to perform the foregoing method for compressing vector data or implement the foregoing decompressing for method vector data.

The n source sub-vectors divided from the source vector data are compressed respectively by using the n sets of multiplexers, to obtain the n target sub-vectors. Then, the n target sub-vectors are shifted and merged to obtain the target vector data, that is, compressed source vector data. In this way, divide-and-conquer processing of vector data is implemented. Therefore, a plurality of multiplexers with a high parallelism degree are not required, a quantity of access ports of the multiplexers can be reduced, and a quantity of multiplexers to which the output ports of the source vector register need to be connected is reduced, thereby reducing a quantity of wires required for vector data compression in the processor and wire intersections are reduced, significantly reducing a congestion level of the wires required for vector data compression in the processor, and significantly reducing an area of the processor, especially an area of a processor with a high vector processing parallelism degree. The reduction of the area of the processor reduces manufacturing difficulty and manufacturing costs of the processor.

In addition, since the n source sub-vectors are compressed respectively by using the n sets of multiplexers, a compression delay of the vector data is reduced, and compression efficiency of the vector data is improved.

### BRIEF DESCRIPTION OF THE DRAWINGS

FIG. 1 is a schematic diagram of a processor (corresponding to vector data compression) in the related art.
FIG. 2 is a schematic diagram of a processor (corresponding to vector data compression) according to an embodiment of this application.
FIG. 3 is a schematic diagram of a processor (corresponding to vector data compression) according to another embodiment of this application.
FIG. 4 is a flowchart of a method for compressing vector data according to an embodiment of this application.
FIG. 5 is a schematic diagram of source vector data and compressed source vector data according to an embodiment of this application.
FIG. 6 is a schematic diagram of a source sub-vector and a compressed source sub-vector according to an embodiment of this application.
FIG. 7 is a schematic diagram of a method for merging a to-be-merged vector according to an embodiment of this application.
FIG. 8 is a schematic diagram of a method for obtaining a filled to-be-merged vector according to an embodiment of this application.
FIG. 9 is a schematic diagram of a processor (corresponding to vector data decompression) according to an embodiment of this application.
FIG. 10 is a schematic diagram of a processor (corresponding to vector data decompression) according to another embodiment of this application.
FIG. 11 is a flowchart of a method for decompressing vector data according to an embodiment of this application.
FIG. 12 is a schematic diagram of target vector data and decompressed target vector data according to an embodiment of this application.
FIG. 13 is a schematic diagram of a target sub-vector and a decompressed target sub-vector according to an embodiment of this application.
FIG. 14 is a schematic diagram of a method for splitting a to-be-split vector according to an embodiment of this application.
FIG. 15 is a block diagram of an apparatus for compressing vector data according to an embodiment of this application.
FIG. 16 is a block diagram of an apparatus for decompressing vector data according to an embodiment of this application.
FIG. 17 is a block diagram of a computer device according to an embodiment of this application.

### DESCRIPTION OF EMBODIMENTS

In order to make objectives, technical solutions, and advantages of this application clearer, implementations of this application are further described in detail below with reference to the drawings.

In the related art, a plurality of MUXes are usually used to compress entire vector data (or vector data). For example, the MUXes successively select an element from the vector data based on a data compression instruction, so that valid elements in the vector data are concentrated at a header of the vector data, and invalid elements in the vector data are concentrated at a tail of the vector data, thereby obtaining compressed vector data. A valid element may be an element useful for inference and training of a processor (such as an AI processor), and an invalid element may be an element useless for inference and training of a processor (such as an AI processor). In the related art, as a vector processing parallelism degree of the AI processor increases, a quantity of required MUXes increases, and a quantity of MUX ports increases sharply, which results in severe wire congestion and a large area of the AI processor.

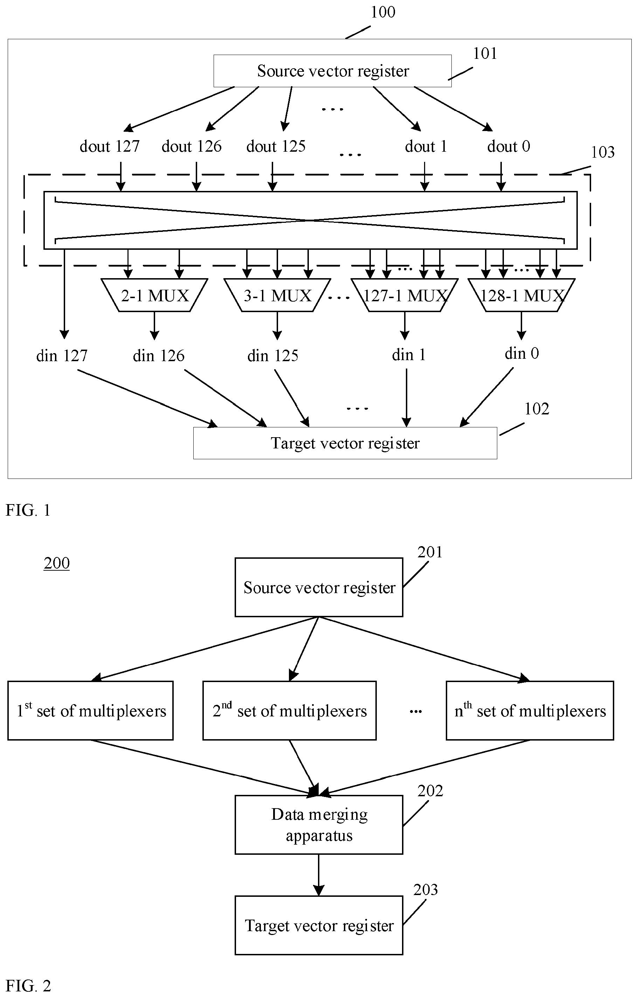

For example, FIG. 1 is a schematic diagram of a processor according to the related art. A vector processing parallelism degree of a processor 100 is 128, that is, 128 elements are simultaneously input into the processor 100. The processor 100 may be an AI processor. The processor 100 may be configured to execute a data compression instruction. The data compression instruction is an instruction to compress valid elements in source vector data to a header and crow invalid elements out. Optionally, the processor 100 may be an AI chip. The processor 100 may also be referred to as a vector compression unit. This is not limited in the embodiments of this application.

The processor 100 includes a source vector register 101, a target vector register 102, and 127 multiplexers. The source vector register 101 is configured to store source vector data. The source vector data is to-be-compressed vector data. Optionally, the source vector register 101 has 128 output ports, which are successively dout 0 to dout 127 in ascending order of bis (that is, from right to left).

The 127 multiplexers are successively: 128-1 multiplexer (128-1 MUX), 127-1 multiplexer (127-1 MUX), ..., 2-1 multiplexer (2-1 MUX) in ascending order of bis. An input port of the 128-1 multiplexer is connected to the 128 output ports of the source vector register 101 (optionally, any connection regarding a port herein is an electrical connection), and is configured to select the 1^{st} valid element (in ascending order of bits) from the 128 elements corresponding to the source vector data. An output port of the 128-1 multiplexer is connected to an input port din 0 of the target vector register 102, and is configured to input the 1^{st} valid element into the target vector register 102. The target vector register 102 is configured to store target vector data, that is, compressed source vector data. Optionally, the target vector register 102 may be configured to store valid elements in the target vector data. Optionally, the target vector register 102 has 128 input ports, which are successively din 0 to din 127 in ascending order of bis (that is, from right to left).

An input port of the 127-1 multiplexer is connected to the 127^{th} high-bit output port of the source vector register 101 (that is, the 127^{th} output port starting from the left), and is configured to select the 2^{nd} valid element from the 127 elements corresponding to the source vector data (excluding an element corresponding to dout 0). An output port of the 127-1 multiplexer is connected to the input port din 1 of the target vector register 102, and is configured to output the 2^{nd} valid element into the target vector register 102.

Through the 127 multiplexers, the elements in the source vector data can be selectively arranged, to obtain the compressed source vector data, that is, the target vector data. The output port dout 127 of the source vector register is directly connected to the input port din 127 of the target vector register. In this way, the last element corresponding to the source vector data can be directly input into the target vector register.

It may be learned that, based on the foregoing hardware architecture required for data compression, in a case that the processor has a high vector processing parallelism degree, a large quantity of wires exist in a wire region 103. For example, if the vector processing parallelism degree of the processor is 128, 128+127+126+...+3+2+1=8256 wires exist in the wire region 103. In this case, as the vector processing parallelism degree of the processor increases, the quantity of wires in the wire region 103 increases sharply, which significantly increases a wire congestion level, and even results in a failure in convergence, causing excessively large wire pressure. In addition, an area of the processor 100 is significantly increased, resulting in an increase in manufacturing difficulty and manufacturing costs of the processor. Moreover, in the wire region 103, many wires intersect. For example, the output port dout 127 of the source vector register needs to be connected to each multiplexer, and the output port dout 126 of the source vector register also needs to be connected to each multiplexer, which causes a plurality of wire intersections. As the vector processing parallelism degree of the processor increases, wire intersections increase, which further increases the wire pressure.

The embodiments of this application provide a method for compressing vector data, which can realize divide-and-conquer processing of the vector data. Therefore, a plurality of multiplexers with a high parallelism degree are not required, a quantity of access ports of the multiplexers can be reduced, and a quantity of multiplexers to which the output ports of the source vector register need to be connected is reduced, thereby reducing a quantity of wires required for vector data compression in the processor and wire intersections are reduced, significantly reducing a congestion level of the wires required for vector data compression in the processor, and significantly reducing an area of the processor, especially an area of a processor with a high vector processing parallelism degree. The reduction of the area of the processor reduces manufacturing difficulty and manufacturing costs of the processor. The method for compressing vector data provided in this application is described in detail below.

FIG. 2 is a schematic diagram of a processor according to an embodiment of this application. A processor 200 includes a source vector register 201, n sets of multiplexers, a data merging apparatus 202, and a target vector register 203. Each set of multiplexers include at least two multiplexers, and n is an integer greater than 1.

The source vector register 201 includes n sets of output ports, the n sets of output ports being respectively connected to input ports of the n sets of multiplexers. A p^{th} set of output ports in the n sets of output ports are connected to input ports of a p^{th} set of multiplexers in the n sets of multiplexers, p being a positive integer less than or equal to n.

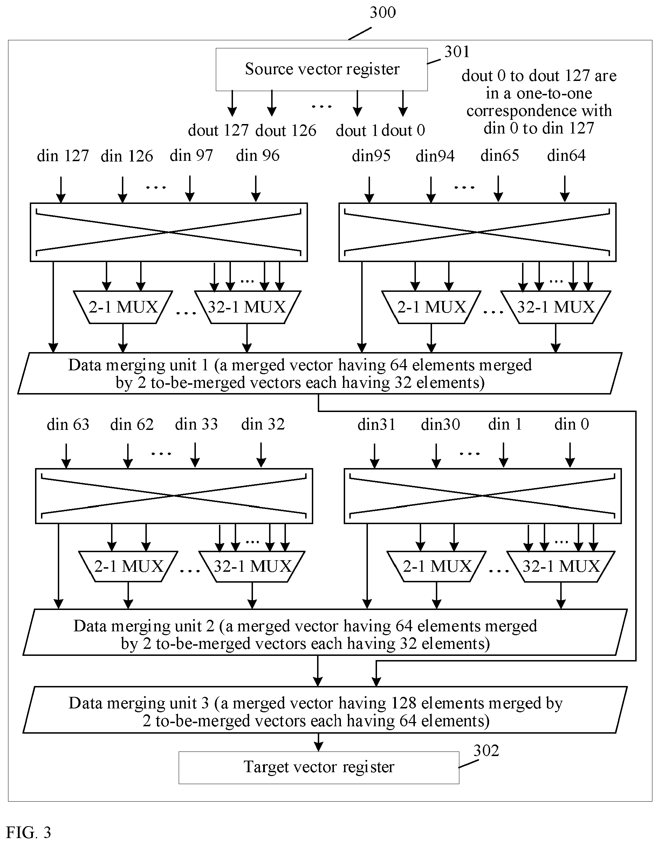

For example, referring to FIG. 3, the vector processing parallelism degree of the processor is 128. 128 output ports (that is, dout 127 to dout 0 in FIG. 3) of a source vector register 301 are divided into 4 sets. The 1^{st} set of output ports (dout 127 to dout 96) are connected to input ports (din 127 to din 96) of the 1^{st} set of multiplexers in a one-to-one correspondence. The 2^{nd} set of output ports (dout 95 to dout 64) are connected to input ports (din 95 to din 64) of the 2^{nd} set of multiplexers in a one-to-one correspondence. The 3^{rd} set of output ports (dout 63 to dout 32) are connected to input ports (din 63 to din 32) of the 3^{rd} set of multiplexers in a one-to-one correspondence. The 4^{th} set of output ports (dout 31 to dout 0) are connected to input ports (din 31 to din 0) of the 4^{th} set of multiplexers in a one-to-one correspondence.

Optionally, n may be set as an integer multiple of 2, such as 2, 4, or 6, to facilitate arrangement of hardware of the processor, such as wires and multiplexers. This is not limited in this embodiment of this application.

In an example, the p^{th} set of output ports include x output ports, and the p^{th} set of multiplexers include x-1 multiplexers, x being a positive integer. The p^{th} set of output ports may be any set of output ports in the n sets of output ports. Optionally, the n sets of output ports may be uniformly divided, or each set of output ports may be configured with different output port quantities. This is not limited in this embodiment of this application. For example, referring to FIG. 3, each set of output ports include 32 output ports, and therefore each set of multiplexers include 31 multiplexers.

Optionally, an a^{th} multiplexer in the x-1 multiplexers includes x-a+1 input ports in ascending order of bits, the x-a+1 input ports corresponding to the a^{th} multiplexer being connected to x-a+1 output ports of the p^{th} set of output ports in a one-to-one correspondence in descending order of bits, a being a positive integer less than x.

For example, referring to FIG. 3, the 1^{st} multiplexer (that is, a 32-1 multiplexer) in the 1^{st} set of multiplexers (din 127 to din 96) includes 32-1+1=32 input ports in ascending order of bits. The 32 input ports of the 1^{st} multiplexer are in connected to 32 output ports of the 1^{st} set of output ports (dout 127 to dout 96) in a one-to-one correspondence in descending order of bits. For another example, in ascending order of bits, the 2^{nd} multiplexer (that is, a 31-1 multiplexer, which is not shown in FIG. 3) in the 1^{st} set of multiplexers (din 127 to din 96) includes 32-2+1=31 input ports. The 31 input ports of the 2^{nd} multiplexer are connected in a one-to-one correspondence to 31 output ports (that is, dout 127 to dout 97) of the 1^{st} set of output ports (dout 127 to dout 96) starting from left in descending order of bits.

Optionally, a first output port of the p^{th} set of output ports is connected to an input port of the data merging apparatus 202. The first output port is the first one of the output ports corresponding to the p^{th} set of output ports in descending order of bits. For example, referring to FIG. 3, the 1^{st} output port (that is, dout 127) of the 1^{st} set of output ports is directly connected to an input port of a data merging unit 1 in the data merging apparatus.

In an example, output ports of the n sets of multiplexers are connected to the input port of the data merging apparatus 202. For example, the data merging apparatus 202 includes m sets of data merging units, m being a positive integer.

Input ports of data merging units in the first set of data merging units are respectively connected to output ports of two adjacent sets of multiplexers. For example, referring to FIG. 3, the data merging apparatus includes 2 sets of data merging units. The 1^{st} set of data merging units include the data merging unit 1 and a data merging unit 2. The 2^{nd} set of data merging units include a data merging unit 3. The input port of the data merging unit 1 is connected to the output ports (din 127 to din 96) of the 1^{st} set of multiplexers and output ports (din 95 to din 64) of the 2^{nd} set of multiplexers. An input port of the data merging unit 2 is connected to output ports (din 63 to din 32) of the 3^{rd} set of multiplexers and output ports (din 31 to din 0) of the 4^{th} set of multiplexers.

Optionally, input ports of the data merging units in a z^{th} set of data merging units are respectively connected to output ports of adjacent data merging units in a (z-1)^{th} set of data merging units, z being an integer greater than 1. For example, referring to FIG. 3, an input port of the data merging unit 3 in the 2^{nd} set of data merging units is connected to an output port of the data merging unit 1 and an output port of the data merging unit 2 in the 1^{st} set of data merging units.

Optionally, in a case that a quantity of the data merging units in the z^{th} set of data merging units is an odd number, an output port of a target data merging unit in the z^{th} set of data merging units is connected to an input port of a target data merging unit in a (z+1)^{th} set of data merging units, the target data merging unit being the last data merging unit or the first data merging unit in each set of data merging units in descending order of bits. For example, in a case that the quantity of the data merging units in the 1^{st} set of data merging units is 3, an output port of the last data merging unit in the 1^{st} set of data merging units is connected to an input port of the last data merging unit in the 2^{nd} set of data merging units; or an output port of the first data merging unit in the 1^{st} set of data merging units is connected to an input port of the first data merging unit in the 2^{nd} set of data merging units.

An input port of the target vector register 203 is connected to an output port of the data merging apparatus 202. Exemplarily, output ports of the last set of data merging units in the m sets of data merging units are connected to the input port of the target vector register 203. For example, referring to FIG. 3, an output port of the data merging unit 3 is connected to the input port of the target vector register 302.

Optionally, the data merging unit may be formed by a combination of a shifter and a multiplexer. Exemplarily, the data merging unit may be formed by a combination of a barrel shifter and a 2-1 multiplexer. A method for merging vector data through the barrel shifter and the 2-1 multiplexer will be described below, and therefore is not described herein.

In an exemplary embodiment, referring to FIG. 3, 32+31+...+3+2+1=528 wires exist in a wire region corresponding to each set of multiplexers. In this case, a total of 528*4=2112 wires exist, which is much less than 8256 wires in the related art. In this way, wire pressure and a required wire area are reduced. In addition, since the quantity of wires is significantly reduced, wire intersections is significantly reduced.

A design compiler (a tool configured for circuit synthesis) is used to synthesize data compression hardware in the related art and data compression hardware (such as the processor 100 and the processor 300) in this application. An area of the processor corresponding to the related art is 1031 µm^2, while the area of the processor corresponding to this application is 711 µm^2. Therefore, it may be learned that the area of the processor required for implementing the data compression instruction in this application is significantly less than the area of the processor corresponding to the related art, which is merely 69% of the area of the processor corresponding to the related art. In addition, as the vector processing parallelism degree of the processor increases, the area of the processor is reduced to a larger extent.

In summary, in the technical resolutions provided in the embodiments of this application, n source sub-vectors divided from the source vector data are compressed respectively by using the n sets of multiplexers, to obtain n target sub-vectors. Then, the n target sub-vectors are shifted and merged to obtain target vector data, that is, compressed source vector data. In this way, divide-and-conquer processing of vector data is implemented. Therefore, a plurality of multiplexers with a high parallelism degree are not required, a quantity of access ports of the multiplexers can be reduced, and a quantity of multiplexers to which the output ports of the source vector register need to be connected is reduced, thereby reducing a quantity of wires required for vector data compression in the processor and wire intersections are reduced, significantly reducing a congestion level of the wires required for vector data compression in the processor, and significantly reducing an area of the processor, especially an area of a processor with a high vector processing parallelism degree. The reduction of the area of the processor reduces manufacturing difficulty and manufacturing costs of the processor.

In addition, since the n source sub-vectors are compressed respectively by using the n sets of multiplexers, a compression delay of the vector data is reduced, and compression efficiency of the vector data is improved.

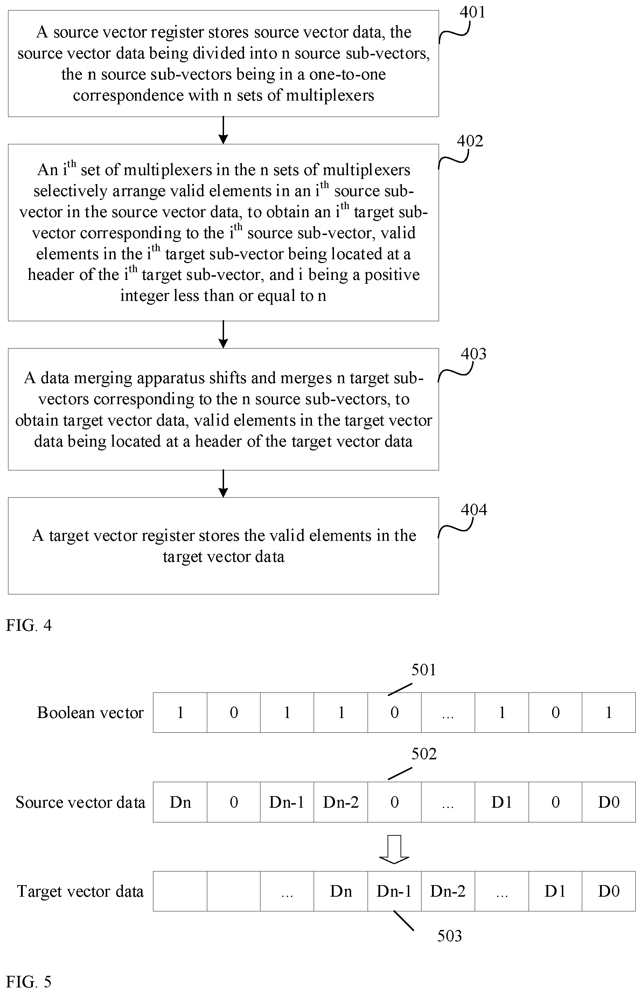

FIG. 4 is a flowchart of a method for compressing vector data according to an embodiment of this application. The method is performed by a processor, such as the processor shown in FIG. 2. The method may include the following steps (401-404).

Step 401: A source vector register stores source vector data, the source vector data being divided into n source sub-vectors, the n source sub-vectors being in a one-to-one correspondence with n sets of multiplexers.

The source vector register is a register configured to store source vector data. The processor may invoke the source vector data from the source vector register based on a data compression instruction. The source vector data is to-be-compressed vector data. In this embodiment of this application, a quantity of elements in the source vector data may be determined based on a vector processing parallelism degree of the processor. For example, the quantity of elements in the source vector data may be the same as the vector processing parallelism degree of the processor.

Optionally, the source vector data may include both valid and invalid elements. A valid element may be an element useful for inference and training of a processor (such as an AI processor), and an invalid element may be an element useless for inference and training of a processor (such as an AI processor). In some examples, the processor not only invokes the source vector data, but also invokes a boolean vector associated with the source vector data. Elements in the boolean vector are configured to indicate a distribution of the valid elements in the source vector data. The boolean vector may be stored in the source vector register or in another register. This is not limited in this embodiment of this application. For example, referring to FIG. 5, each element in a boolean vector 501 is a boolean value. 1 indicates that an element at a corresponding position in source vector data 502 is a valid element. 0 indicates that an element at the corresponding position in the source vector data 502 is an invalid element. In a subsequent vector data compression process, the invalid elements need to be crowded out.

This embodiment of this application introduces a divide-and-conquer strategy, in which the elements of the source vector data are divided into groups for compression (for example, divided into groups for parallel compression) during compression of the source vector data. Exemplarily, referring to FIG. 3, the source vector data is divided into 4 source sub-vectors. Each of the source sub-vectors corresponds to one set of elements in the source vector data. Quantities of elements in the source vector data included in different source sub-vectors may be the same or different. For example, source vector data with 128 elements is uniformly divided into 4 source sub-vectors with 32 elements in descending order of bits. Each 4 source sub-vectors correspond to one set of multiplexers. Each set of multiplexers are configured to compress corresponding source sub-vectors.

Step 402: An i^{th} set of multiplexers in the n sets of multiplexers selectively arrange valid elements in an i^{th} source sub-vector in the source vector data, to obtain an i^{th} target sub-vector corresponding to the i^{th} source sub-vector, valid elements in the i^{th} target sub-vector being located at a header of the i^{th} target sub-vector, and i being a positive integer less than or equal to n.

The i^{th} set of multiplexers may be any set of multiplexers in the n sets of multiplexers. The i^{th} source sub-vector is a source sub-vector corresponding to the i^{th} set of multiplexers. For example, referring to FIG. 3, in descending order of bits, the 1^{st} source sub-vector (composed of elements corresponding to dout 127 to dout 96) corresponds to the 1^{st} set of multiplexers (din 127 to din 96). The 2^{nd} source sub-vector (composed of elements corresponding to dout 95 to dout 64) corresponds to the 2^{nd} set of multiplexers (din 95 to din 64). The 3^{rd} source sub-vector (composed of elements corresponding to dout 63 to dout 32) corresponds to the 3^{rd} set of multiplexers (din 63 to din 32). The 4^{th} source sub-vector (composed of elements corresponding to dout 31 to dout 0) corresponds to the 4^{th} set of multiplexers (din 31 to din 0).

In an example, a quantity of multiplexers in each set of multiplexers may be determined based on a quantity of elements in the source sub-vector. Exemplarily, the i^{th} source sub-vector includes x elements, the x elements including y valid elements, and the i^{th} set of multiplexers include x-1 multiplexers of different types, x being a positive integer, and y being a positive integer less than or equal to x. For example, referring to FIG. 3, in a case that the 1^{st} source sub-vector (composed of the elements corresponding to dout 127 to dout 96) includes 32 elements, the 1^{st} set of multiplexers corresponding to the 1^{st} source sub-vector include 31 multiplexers of different types. In an example, y is a positive integer less than or equal to x-1.

For example, in a compression process of the i^{th} source sub-vector, an obtaining process of the i^{th} target sub-vector corresponding to the i^{th} source sub-vector may include: selecting, by y multiplexers in the x-1 multiplexers, the y valid elements from the x elements in ascending order of bits based on a boolean vector corresponding to the source vector data, and arranging the y valid elements in ascending order of bits, to obtain the i^{th} target sub-vector.

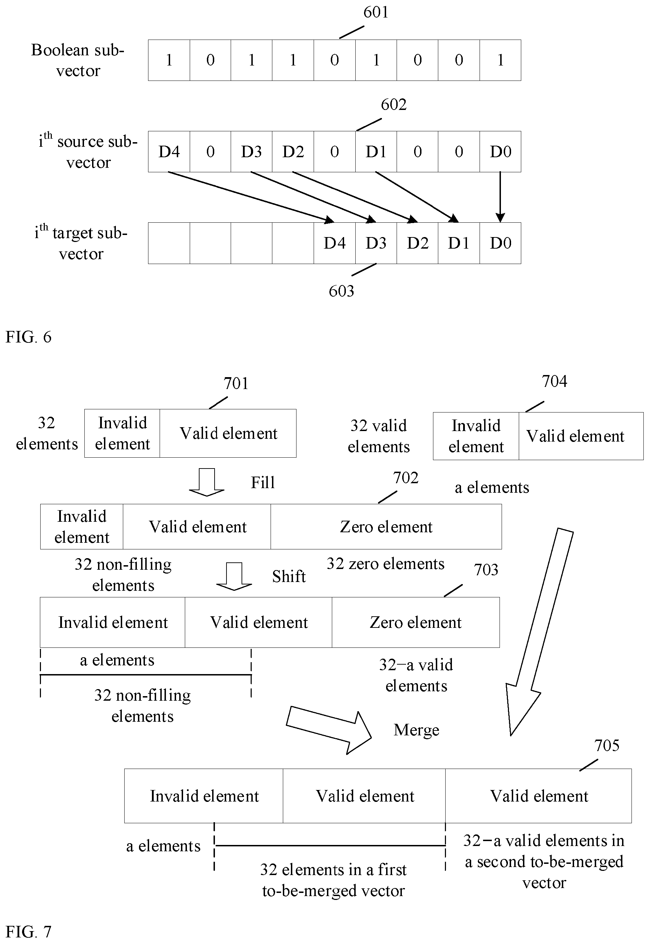

For example, referring to FIG. 6, an i^{th} source sub-vector 602 includes 9 elements. The 9 elements include 5 valid elements, which are successively D0, D1, D2, D3, and D4 in ascending order of bits. The i^{th} source sub-vector 602 corresponds to 5 multiplexers of a set of multiplexers starting from right. Based on a boolean sub-vector 601 (that is, composed of elements in the boolean vector corresponding to the i^{th} source sub-vector), the 5 valid elements are selected from the 9 elements in ascending order of bits, and the 5 valid elements are arranged in ascending order of bits to obtain an i^{th} target sub-vector 603. The 5 valid elements in the i^{th} target sub-vector are arranged in sequence at a header of the i^{th} target sub-vector 603. Optionally, remaining invalid elements may be arranged in sequence at remaining positions in the i^{th} target sub-vector 603in ascending order of bits.

In an example, a specific determination process of an element at each position in the i^{th} target sub-vector may include: selecting, by a z^{th} multiplexer in the y multiplexers, a z^{th} valid element from a z^{th} element to an x^{th} element in the i^{th} source sub-vector in ascending order of bits based on the boolean vector, z being a positive integer less than or equal to y; and adding, by the z^{th} multiplexer, the z^{th} valid element to a z^{th} position of the i^{th} target sub-vector. The z^{th} multiplexer may be any one of the y multiplexers.

For example, referring to FIG. 6, in ascending order of bits, the 1^{st} multiplexer selects the 1^{st} valid element D0 from the 1^{st} to 9^{th} elements in the i^{th} source sub-vector 602 based on the boolean sub-vector 601, and adds the 1^{st} valid element to the 1^{st} position in the i^{th} target sub-vector 603; the 2^{nd} multiplexer selects the 2^{nd} valid element D1 from the 2^{nd} to 9^{th} elements in the i^{th} source sub-vector 602 based on the boolean sub-vector 601, and adds the 2^{nd} valid element to the 2^{nd} position in the i^{th} target sub-vector 603, and so on. In this way, the 5 valid elements corresponding to the i^{th} source sub-vector 602 may be arranged at the header of the i^{th} target sub-vector 603.

Step 403: A data merging apparatus shifts and merges n target sub-vectors corresponding to the n source sub-vectors to obtain target vector data, valid elements in the target vector data being located at a header of the target vector data.

Exemplarily, the n target sub-vectors may be obtained through selective arrangement of valid elements of the n source sub-vectors performed by the n sets of multiplexers in sequence.

Exemplarily, the n target sub-vectors may alternatively be obtained through selective arrangement of valid elements of the n source sub-vectors performed by the n sets of multiplexers in parallel. In this way, parallel compression of the n source sub-vectors can be realized, thereby further reducing a compression delay of the vector data and improving compression efficiency of the vector data.

Optionally, the data merging apparatus includes m sets of data merging units, the m sets of data merging units being configured to perform p rounds of shifting and merging on the n target sub-vectors to obtain the target vector data, m being an integer greater than 1, and p being a positive integer. For example, referring to FIG. 3, the data merging apparatus includes 2 sets of data merging units. The 1^{st} set of data merging units include the data merging unit 1 and a data merging unit 2. The 2^{nd} set of data merging units include a data merging unit 3. The 2 sets of data merging units are configured to perform 2 rounds of shifting and merging on 4 target sub-vectors (composed of output ports of 4 sets of multiplexers respectively).

Optionally, p may be set to be equal to m. In other words, m sets of data merging units may perform m rounds of shifting and merging on the n target sub-vectors to obtain the target vector data. In some embodiments, p may alternatively be set to be unequal to m. For example, p may be set to be less than m or greater than m.

The target vector data is vector data obtained after the source vector data is compressed. Optionally, only the valid elements in the source vector data may be retained in the target vector data, or both the valid and invalid elements in the source vector data may be retained. This is not limited in this embodiment of this application. For example, referring to FIG. 5, through compression of the source vector data 502, target vector data 503 can be obtained. Valid elements (D0 to Dn) in the target vector data 503 are located at a header of the target vector data 503.

In an example, a specific process of the foregoing p rounds of shifting and merging may include: shifting and merging, by a q^{th} set of data merging units in the m sets of data merging units for a q^{th} round of shifting and merging, a q^{th} set of to-be-merged vectors, to obtain a q^{th} set of merged vectors, q being a positive integer less than or equal to p. In a case that q is equal to 1, the q^{th} set of to-be-merged vectors are the n target sub-vectors, and in a case that q is greater than 1, the q^{th} set of to-be-merged vectors are a (q-1)^{th} set of merged vectors, and a p^{th} set of merged vectors are the target vector data.

For example, referring to FIG. 3, the 1^{st} set of data merging units (the data merging unit 1 and the data merging unit 2) are configured to perform the first round of shifting and merging on the 4 target sub-vectors (that is, 4 to-be-merged vectors each having 32 elements) to obtain the 1^{st} set of merged vectors (that is, 2 merged vectors each having 64 elements). The 2^{nd} set of data merging units (the data merging unit 3) are configured to perform the second round of shifting and merging on the 1^{st} set of merged vectors, to obtain the target vector data (that is, 1 merged vector having 128 elements).

In an example, the data merging units in the q^{th} sets of data merging units shift and merge each two adjacent to-be-merged vectors in the q^{th} set of to-be-merged vectors, to obtain the q^{th} set of merged vectors. For example, referring to FIG. 3, the data merging unit 1 in the 1^{st} set of data merging units shifts and merges the 1^{st} target sub-vector (composed of output ports of the 1^{st} set of multiplexers) and the 2^{nd} target sub-vector (composed of output ports of the 2^{nd} set of multiplexers) that are adjacent to each other. The data merging unit 2 in the 1^{st} set of data merging units shifts and merges the 3^{rd} target sub-vector (composed of output ports of the 3^{rd} set of multiplexers) and the 4^{th} target sub-vector (composed of output ports of the 4^{th} set of multiplexers) that are adjacent to each other, to obtain the 1^{st} set of merged vectors.

Exemplarily, the implementation in which the data merging units in the q^{th} sets of data merging units shift and merge each two adjacent to-be-merged vectors in the q^{th} set of to-be-merged vectors, to obtain the q^{th} set of merged vectors is implemented in a case that a quantity of the to-be-merged vectors in the q^{th} set of to-be-merged vectors is an even number. The quantity of the to-be-merged vectors in the q^{th} set of to-be-merged vectors may alternatively be an odd number. Optionally, in a case that a quantity of to-be-merged vectors in the q^{th} set of to-be-merged vectors is an odd number, the data merging apparatus adds a target to-be-merged vector in the q^{th} set of to-be-merged vectors to the q^{th} set of merged vectors. The target to-be-merged vector in the q^{th} set of to-be-merged vectors is the first to-be-merged vector or the last to-be-merged vector in the q^{th} set of to-be-merged vectors in ascending order of bits. For example, in a case that the quantity of the to-be-merged vectors in the q^{th} set of to-be-merged vectors is 3, the 1^{st} to-be-merged vector in the q^{th} set of to-be-merged vectors starting from right may be directly added to the q^{th} set of merged vectors, and the 2^{nd} to-be-merged vector and 3^{rd} to-be-merged vector in the q^{th} set of to-be-merged vectors starting from right may be shifted and merged. Alternatively, the 1^{st} to-be-merged vector in the q^{th} set of to-be-merged vectors starting from left may be directly added to the q^{th} set of merged vectors, and the 2^{nd} to-be-merged vector and 3^{rd} to-be-merged vector in the q^{th} set of to-be-merged vectors starting from left may be shifted and merged.

In an example, in a case that the first data merging unit in the q^{th} set of data merging units shifts and merges the first to-be-merged vector and the second to-be-merged vector in the q^{th} set of to-be-merged vectors, the shifting and merging process may be as follows:

The first data merging unit shifts the first to-be-merged vector based on the second to-be-merged vector, to obtain an adjusted first to-be-merged vector.

An element corresponding to the second to-be-merged vector in the source vector data is at a lower bit than an element corresponding to the first to-be-merged vector in the source vector data. Optionally, the first to-be-merged vector may be referred to as a high-bit to-be-merged vector, and the second to-be-merged vector may be referred to as a low-bit to-be-merged vector. The first data merging unit may be any one data merging unit in the q^{th} set of data merging units. The first to-be-merged vector and the second to-be-merged vector are two to-be-merged vectors corresponding to the first data merging unit adjacent to each other.

Optionally, a specific process of obtaining the adjusted first to-be-merged vector may include: filling, by the first data merging unit, the first to-be-merged vector with elements based on a quantity of elements in the second to-be-merged vector, to obtain a filled first to-be-merged vector, a quantity of elements in the filled first to-be-merged vector being a sum of the quantity of the elements in the second to-be-merged vector and a quantity of elements in the first to-be-merged vector; and shifting, by the first data merging unit, non-filling elements in the filled first to-be-merged vector as a whole based on a quantity of invalid elements in the second to-be-merged vector, to obtain the adjusted first to-be-merged vector, a quantity of non-filling elements corresponding to a header of the adjusted first to-be-merged vector being the same as the quantity of the valid elements in the second to-be-merged vector.

For example, referring to FIG. 7, a first to-be-merged vector 701 has 32 elements, and a second to-be-merged vector 704 has 32 elements. In this case, it may be determined that a filled first to-be-merged vector 702 has 64 elements. Optionally, 32 zero elements are added to a high bit of the first to-be-merged vector 701, then 32 non-filling elements are shifted by 31 bits to the high bit as a whole to obtain the filled first to-be-merged vector 702. Optionally, the 32 non-filling elements may be shifted as a whole by using a shifter. For example, the 32 non-filling elements may be shifted as a whole by using a barrel shifter.

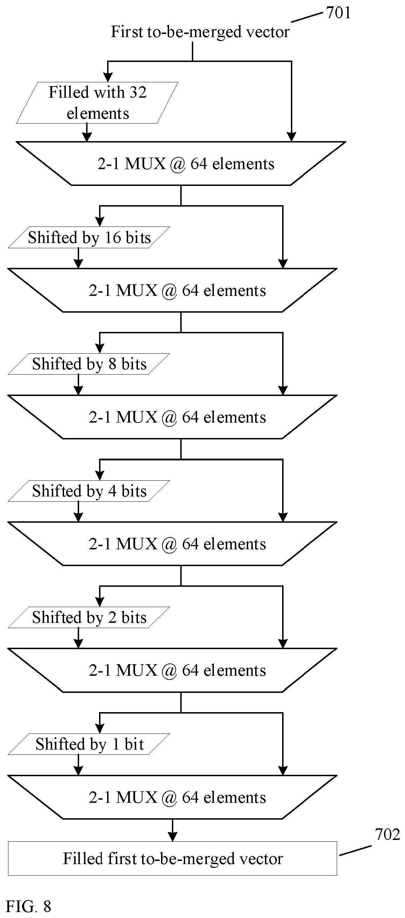

The barrel shifter may be configured to cyclically shift the elements in the vector data leftward. Therefore, a control input merely needs to specify a quantity of to-be-shifted bits. The quantity of to-be-shifted bits is represented a binary numerical string (referred to as S in short below). For example, it is assumed that the barrel shifter corresponds to 64 input ports and 64 output ports. When S=00000, which indicates that the elements need to be cyclically shifted leftward by 0 bits, dout 63=din 63. When S=11111, which indicates that the elements need to be cyclically shifted leftward by 31 bits, and dout 63=din 31. Optionally, shifting may be performed a plurality of times step by step. For example, when S=11111, the elements may be shifted by 16 bits, 8 bits, 4 bits, 2 bits, and 1 bit successively. Exemplarily, referring to FIG. 8, when S=11111, the process may specifically be as follows:

After the first to-be-merged vector 701 is filled with the elements, the first to-be-merged vector 701 filled with the elements and the first to-be-merged vector 701 may be merged by using the 2-1 multiplexer, to obtain a transitional to-be-merged vector with 64 elements. Then S=10000 is set, so that the barrel shifter circularly shifts the non-filling elements leftward by 16 bits. The transitional to-be-merged vector after the first shifting is merged with the transitional to-be-merged vector by using the 2-1 multiplexer, to obtain a first intermediate vector. Then S=01000 is set, so that the barrel shifter circularly shifts the non-filling elements leftward by 8 bits; then S=00100 is set, so that the barrel shifter circularly shifts the non-filling elements leftward by 4 bits; then S=00010 is set, so that the barrel shifter circularly shifts the non-filling elements leftward by 2 bits; and finally S=00001 is set, so that the barrel shifter circularly shifts the non-filling elements leftward by 1 bit, thereby obtaining an adjusted first to-be-merged vector 702.

It is assumed that the second to-be-merged vector 704 includes an invalid elements and 32-a valid elements. In this case, 32 non-filling elements in the filled first to-be-merged vector 702 may be shifted toward a low bit by 32-a-1 bits (that is, S=32-a-1) as a whole through the barrel shifter, to obtain an adjusted first to-be-merged vector 703. A lower bit of the adjusted first to-be-merged vector 703 includes 32-a positions, to place the 32-a valid elements in the second to-be-merged vector 704.

In some embodiments, the non-filling elements in the first to-be-merged vector filled with the elements may be directly shifted toward the high bit as a whole based on the quantity of valid elements in the second to-be-merged vector, and the quantity of valid elements in the second to-be-merged vector is reduced by 1 bit.

2. The first data merging unit merges the adjusted first to-be-merged vector and the second to-be-merged vector, to obtain a first merged vector corresponding to the q^{th} set of merged vectors.

Optionally, the first data merging unit selects elements corresponding to the first merged vector from the adjusted first to-be-merged vector and the second to-be-merged vector in ascending order of bits. The first data merging unit selects, for a k^{th} element corresponding to the first merged vector, one of a k^{th} element in the adjusted first to-be-merged vector and a k^{th} element in the second to-be-merged vector as the k^{th} element corresponding to the first merged vector, k being a positive integer. The k^{th} element may be any element in the first merged vector.

Exemplarily, in a case that the k^{th} element in the adjusted first to-be-merged vector is a valid element, the first data merging unit determines the k^{th} element in the adjusted first to-be-merged vector as the k^{th} element corresponding to the first merged vector. Alternatively, in a case that the k^{th} element in the second to-be-merged vector is a valid element, the first data merging unit determines the k^{th} element in the second to-be-merged vector as the k^{th} element corresponding to the first merged vector. Exemplarily, the k^{th} element in the adjusted first to-be-merged vector being a valid element means that the k^{th} element in the adjusted first to-be-merged vector is a valid element and the k^{th} element in the second to-be-merged vector is an invalid element. The k^{th} element in the second to-be-merged vector being a valid element means that the k^{th} element in the second to-be-merged vector is a valid element and the k^{th} element in the adjusted first to-be-merged vector is an invalid element.

Exemplarily, in a case that the k^{th} element in the adjusted first to-be-merged vector and the k^{th} element in the second to-be-merged vector are both invalid elements, the first data merging unit may select either of the k^{th} element in the adjusted first to-be-merged vector and the k^{th} element in the second to-be-merged vector as the k^{th} element corresponding to the first merged vector. Exemplarily, in a case that the k^{th} element in the adjusted first to-be-merged vector and the k^{th} element in the second to-be-merged vector are both valid elements, the first data merging unit may select either of the k^{th} element in the adjusted first to-be-merged vector and the k^{th} element in the second to-be-merged vector as the k^{th} element corresponding to the first merged vector.

For example, referring to FIG. 7, a low bit of the adjusted first to-be-merged vector 703 has 32-a positions. Elements corresponding to the 32-a positions are all zero elements, which are equivalent to invalid elements. The 2-1 multiplexer in the first data merging unit has two input ports. One of the input ports is configured to obtain elements corresponding to the adjusted first to-be-merged vector 703. The other input port is configured to obtain the elements corresponding to the second to-be-merged vector 704. For example, in ascending order of bits, the 1^{st} element corresponding to the adjusted first to-be-merged vector 703 is a zero element, and the 1^{st} element corresponding to the second to-be-merged vector 704 is a valid element. Therefore, the 1^{st} element corresponding to the second to-be-merged vector 704 is determined as the 1^{st} element of a first merged vector 705. In this way, the valid elements in the first to-be-merged vector 701 and the second to-be-merged vector 704 may be successively compressed to a header of the first merged vector 705, and an arrangement sequence of the valid elements conforms with the boolean vector. Optionally, when two inputs of the 2-1 multiplexer are both invalid elements, one of the inputs is selected.

After p rounds of shifting and merging, the target vector data may be obtained. During each round of shifting and merging, the elements are shifted by a fixed quantity of bits or not shifted, and an input of each data merging unit has only two vectors, and has no wire intersection, which reduces the wire pressure and the area of the processor.

Step 404: A target vector register stores valid elements in the target vector data.

The target vector register may be configured to store all elements in the target vector data, or store only the valid elements in the target vector data. This is not limited in this embodiment of this application. Optionally, in a case that the target vector data is required, only the valid elements in the target vector data may be directly invoked. The source vector data may be obtained through decompression based on the valid elements in the target vector data and the boolean vector.

In summary, in the technical resolutions provided in the embodiments of this application, the n source sub-vectors divided from the source vector data are compressed respectively by using the n sets of multiplexers, to obtain n target sub-vectors. Then, the n target sub-vectors are shifted and merged to obtain target vector data, that is, compressed source vector data. In this way, divide-and-conquer processing of vector data is implemented. Therefore, a plurality of multiplexers with a high parallelism degree are not required, a quantity of access ports of the multiplexers can be reduced, and a quantity of multiplexers to which the output ports of the source vector register need to be connected is reduced, thereby reducing a quantity of wires required for vector data compression in the processor and wire intersections are reduced, significantly reducing a congestion level of the wires required for vector data compression in the processor, and significantly reducing an area of the processor, especially an area of a processor with a high vector processing parallelism degree. The reduction of the area of the processor reduces manufacturing difficulty and manufacturing costs of the processor.

In addition, since the n source sub-vectors are compressed respectively by using the n sets of multiplexers, a compression delay of the vector data is reduced, and compression efficiency of the vector data is improved. During compression of the n source sub-vectors by using the n sets of multiplexers, the n sets of multiplexers may perform parallel compression on the n source sub-vectors, thereby further reducing the compression delay of the vector data and improving the compression efficiency of the vector data.

In addition, during merging of two adjacent to-be-merged vectors, high-bit to-be-merged vectors are shifted by using a logarithmic shifter, which further reduces the area of the processor.

In addition, hierarchical merging of the to-be-merged vectors facilitates division and realization of a pipeline, which can further improve the compression efficiency of the vector data, thereby improving performance of the data compression instruction.

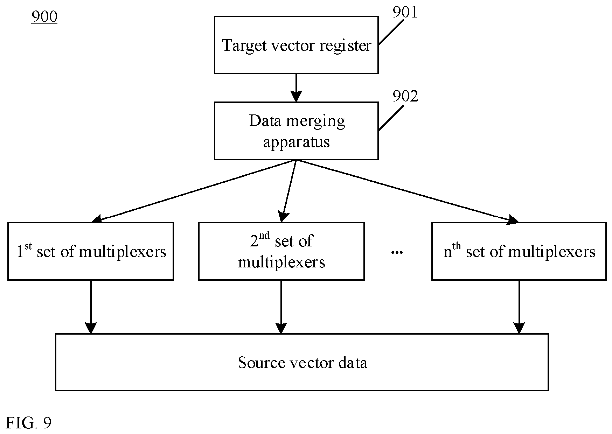

FIG. 9 is a schematic diagram of a processor according to another embodiment of this application. A processor 900 includes a target vector register 901, a data splitting apparatus 902, and n sets of multiplexers. Each set of multiplexers include at least two multiplexers, and n is an integer greater than 1.

In this embodiment of this application, the processor 900 is configured to decompress compressed vector data. For example, the processor 900 decompresses target vector data into source vector data based on a boolean vector based on a data decompression instruction. The data decompression instruction is used for indicating that valid elements in the target vector data need to be decompressed to a position specified in the boolean vector and remaining positions need to be filled with invalid data. Optionally, the processor 900 may be an AI processor or an AI chip. The processor 900 may alternatively be referred to a vector decompression unit.

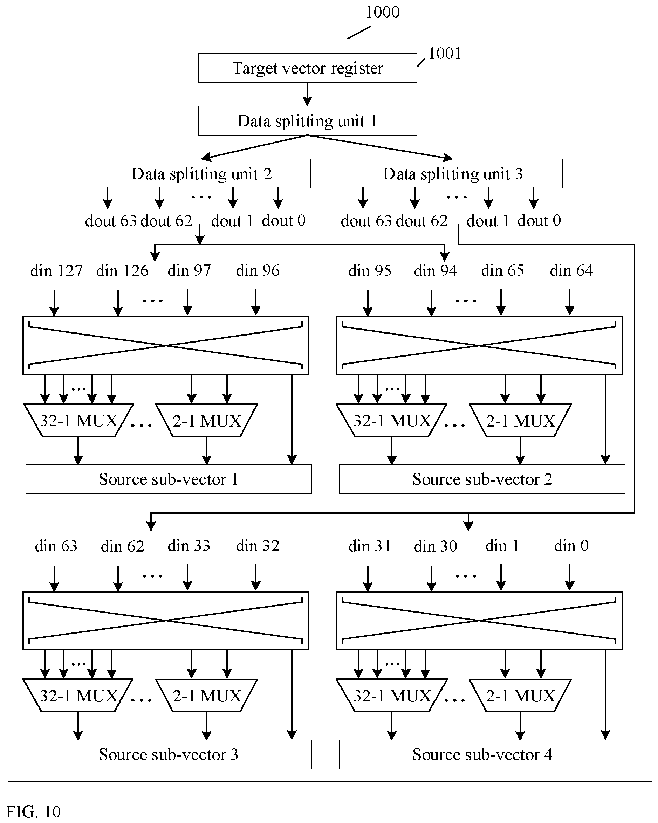

An output port of the target vector register 901 is connected to an input port of the data splitting apparatus 902. Optionally, the data splitting apparatus 902 includes m sets of data splitting units, m being a positive integer. A quantity of data splitting units in each set of data splitting units is not limited in this embodiment of this application. Exemplarily, referring to FIG. 10, a vector processing parallelism degree of a processor 1000 is 128. In the processor 1000, a data splitting apparatus includes 2 sets of data splitting units. The first set of data splitting units include a data splitting unit 1. The second set of data splitting units include a data splitting unit 2 and a data splitting unit 3.

Optionally, an input port of the data splitting unit in the first set of data splitting units in the m sets of data splitting units is connected to an output port of a target vector register. For any set of data splitting units in the remaining m-1 sets of data splitting units, for example, a z^{th} set of data splitting units, input ports of the data splitting units in the z^{th} set of data splitting units are connected to output ports of data splitting units in a (z-1)^{th} set of data splitting units. z is an integer greater than 1 and not greater than m.

For example, referring to FIG. 10, the input port of the data splitting unit 1 in the first set of data splitting units is connected to an output port of a target vector register 1001. An input port of the data splitting unit 2 in the second set of data splitting units is connected to an output port of the data splitting unit 1. In addition, an input port of the data splitting unit 3 in the second set of data splitting units is connected to the output port of the data splitting unit 1. Optionally, a quantity of connection ports between the data splitting unit 2 and the data splitting unit 1 may be the same as a quantity of connection ports between the data splitting unit 3 and the data splitting unit 1.

An output port of the data splitting apparatus 902 is connected to the input ports of the n sets of multiplexers. Exemplarily, output ports of data splitting units in an m^{th} set of data splitting units are connected to the input ports of the n sets of multiplexers. For example, referring to FIG. 10, the output port of the data splitting unit 2 in the second set of data splitting units is connected to the input ports (din 127 to din 96) of the 1^{st} set of multiplexers and the input ports (din 95 to din 64) of the 2^{nd} set of multiplexers. An output port of the data splitting unit 3 in the second set of data splitting units is connected to the input ports (din 63 to din 32) of the 3^{rd} set of multiplexers and the input ports (din 31 to din 0) of the 4^{th} set of multiplexers.

In an example, for the m^{th} set of data splitting units (that is, the last set of data splitting units), a target data splitting unit in the m^{th} set of data splitting units includes x output ports. The target data splitting unit corresponds to at least two sets of multiplexers. x is a positive integer. For example, referring to FIG. 10, the data splitting unit 2 corresponds to 64 output ports. 32 output ports starting from left are connected in a one-to-one correspondence to the input ports (din 127 to din 96) corresponding to the 1^{st} set of multiplexers. 32 output ports on the right therein are connected in a one-to-one correspondence to input ports (din 95 to din 64) corresponding to the 2^{nd} set of multiplexers. The target data splitting unit is any data splitting unit in the m^{th} set of data splitting units.

Optionally, for a target set of multiplexers corresponding to the target data splitting unit, a quantity of the multiplexers in the target set of multiplexers is equal to a quantity of connection ports between the target data splitting unit and the target set of multiplexers minus 1 (denoted as u-1). The target set of multiplexers are any set of multiplexers of at least two sets of multiplexers corresponding to the target data splitting unit.

Exemplarily, in descending order of bits, a p^{th} multiplexer in the target set of multiplexers includes u-p+1 input ports. The u-p+1 input ports corresponding to the p^{th} multiplexer are connected in a one-to-one correspondence to u output ports corresponding to the target data splitting unit in ascending order of bits. p is a positive integer less than u. A first output port of the target data splitting unit is not connected to the multiplexer. The first output port is the first one of the output ports corresponding to the target data splitting unit in ascending order of bits.

For example, referring to FIG. 10, the 32 input ports of the 1^{st} multiplexer in the 1^{st} set of multiplexers are connected in a one-to-one correspondence to 32 output ports of the data splitting unit 2 starting from left; the 31 input ports of the 2^{nd} multiplexer in the 1^{st} set of multiplexers are connected in a one-to-one correspondence to the 2^{nd} output port to the 32^{nd} output port corresponding to the data splitting unit 2 starting from left; and so on. Optionally, the 32^{nd} output port (that is, dout 32) corresponding to the data splitting unit 2 starting from left is not connected to the multiplexer. The output port may be directly outputted as the first element corresponding to a source sub-vector 1 starting from right.

In summary, in the technical resolutions provided in this embodiment of this application, divide-and-conquer decompression of the target vector data is realized. Therefore, a plurality of multiplexers with a high parallelism degree are not required, a quantity of access ports of the multiplexers can be reduced, and a quantity of multiplexers to which the output ports of the target vector register need to be connected is reduced, thereby reducing a quantity of wires required for vector data decompression in the processor and wire intersections are reduced, significantly reducing a congestion level of the wires required for vector data decompression in the processor, and significantly reducing an area of the processor, especially an area of a processor with a high vector processing parallelism degree. The reduction of the area of the processor reduces manufacturing difficulty and manufacturing costs of the processor.

In addition, through the divide-and-conquer decompression of the target vector data, a decompression delay of the target vector data is reduced, thereby improving decompression efficiency of the target vector data.

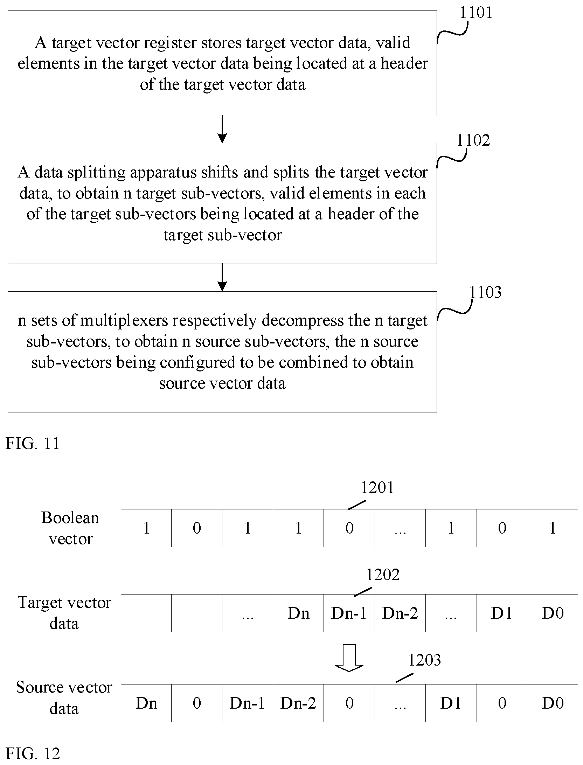

FIG. 11 is a flowchart of a method for decompressing vector data according to an embodiment of this application. The method for decompressing vector data is performed by a processor, such as the processor shown in FIG. 9. The method may include the following steps (1101-1103).

Step 1101: A target vector register stores target vector data, valid elements in the target vector data being located at a header of the target vector data.

The target vector register may be configured to store only the valid elements in the target vector data, or may be configured to store all elements in the target vector data. Optionally, in a case that the target vector register stores only the valid elements in the target vector data, elements are filled based on a boolean vector, to obtain the target vector data. For example, referring to FIG. 12, valid elements (Dn-D0) in target vector data 1202 are located at a header of the target vector data 1202.

Step 1102: A data splitting apparatus shifts and splits the target vector data to obtain n target sub-vectors, valid elements in each of the target sub-vectors being located at a header of the target sub-vector.

The data splitting apparatus is configured to split the target vector data. The data splitting apparatus may extract the target vector data from the target vector register based on a data decompression instruction. Optionally, a value of n is not limited in this embodiment of this application. For example, n may be set to a multiple of 2, or n may be set to a multiple of 4.

Optionally, the data splitting apparatus includes m sets of data splitting units, the m sets of data splitting units being configured to perform p rounds of shifting and splitting on the target vector data to obtain the n target sub-vectors, m being an integer greater than 1, and p being a positive integer.

Exemplarily, a q^{th} set of data splitting units in the m sets of data splitting units shifts and splits, for a q^{th} round of shifting and splitting, a q^{th} set of to-be-split vectors, to obtain a q^{th} set of split vectors, q being a positive integer less than or equal to p; and in a case that q is equal to 1, the q^{th} set of to-be-split vectors being the target vector data, and in a case that q is greater than 1, the q^{th} set of to-be-split vectors being a (q-1)^{th} set of split vectors, and a p^{th} set of split vectors being the n target sub-vectors.

For example, referring to FIG. 10, the data splitting apparatus includes 2 sets of data splitting units. The first set of data splitting units include the data splitting unit 1. The second set of data splitting units include the data splitting unit 2 and the data splitting unit 3. The first set of data splitting units are configured to shift and split the 1^{st} set of to-be-split vectors (that is, the target vector data) to obtain the 1^{st} set of split vectors. The second set of data splitting units are configured to shift and split the 2^{nd} set of to-be-split vectors (that is, the 1^{st} set of split vectors) to obtain the 2^{nd} set of split vectors, that is, 4 target sub-vectors (a target sub-vector 1 is composed of the outputs of the 32 output ports of the data splitting unit 2 starting from left, a target sub-vector 2 is composed of outputs of 32 output ports of the data splitting unit 2 starting from right, a target sub-vector 3 is composed of outputs of 32 output ports of the data splitting unit 3 starting from left, and a target sub-vector 4 is composed of outputs of 32 output ports of the data splitting unit 3 from the right, which are not shown in FIG. 10).

In an example, the q^{th} set of split vectors include s split vectors corresponding to the first to-be-split vector in the q^{th} set of to-be-split vectors. In a case that the first data splitting unit in the q^{th} set of data splitting units shifts and splits the first to-be-split vector in the q^{th} set of to-be-split vectors, the s split vectors corresponding to the first to-be-split vector may be obtained by using the following process.

The first data splitting unit determines s split element quantities corresponding to the first to-be-split vector, s being an integer greater than 1.

The first to-be-split vector may be any to-be-split vector in the q^{th} set of to-be-split vectors. The first data splitting unit may be a data splitting unit in the q^{th} set of data splitting units configured to shift and split the first to-be-split vector. A split element quantity is used for indicating an element quantity in an obtained split vector. s may be set and adjusted based on an actual use requirement.

For example, referring to FIG. 10, each to-be-split vector corresponds to 2 split element quantities. In other words, each data splitting unit splits a to-be-split vector into 2 split vectors. Optionally, quantities of elements in two split vectors corresponding to the same to-be-split vector are the same or different. In FIG. 10, the data splitting unit 1 splits the target vector data into two split vectors each having 64 elements, the data splitting unit 2 splits one of the split vectors having 64 elements into two split vectors each having 32 elements, that is, the target sub-vector 1 and the target sub-vector 2, and the data splitting unit 3 splits another split vector having 64 elements into two split vectors each having 32 elements, that is, the target sub-vector 3 and the target sub-vector 4.

2. The first data splitting unit determines s sets of valid split elements based on a boolean vector corresponding to the target vector data and the s split element quantities. An element in the boolean vector is used for indicating a distribution of valid elements in the source vector data.

For example, referring to FIG. 12, if it is assumed that the 1^{st} split element quantity is 5 in descending order of bits, a valid split element quantity corresponding to the 1^{st} split element quantity is 3 (that is, three 1 exist in 5 boolean values starting from left). In this way, the s sets of valid split elements respectively corresponding to the s split element quantities can be obtained.

3. The first data splitting unit respectively shifts the s sets of valid split elements as a whole in the first to-be-split vector based on the s sets of valid split elements, to obtain a shifted first to-be-split vector.

Optionally, the first data splitting unit determines, for a target split element quantity in the s split element quantities, a quantity of target to-be-shifted bits corresponding to the target split element quantity based on a difference between a position of a target valid split element corresponding to the target split element quantity in the first to-be-split vector and a position of the target split element corresponding to the target split element quantity in the boolean vector. The target valid split element corresponding to the target split element quantity is the last valid split element corresponding to the target split element quantity in descending order of bits, and the target split element corresponding to the target split element quantity is the last split element corresponding to the target split element quantity in descending order of bits. The target split element quantity is any split element quantity in the s split element quantities.

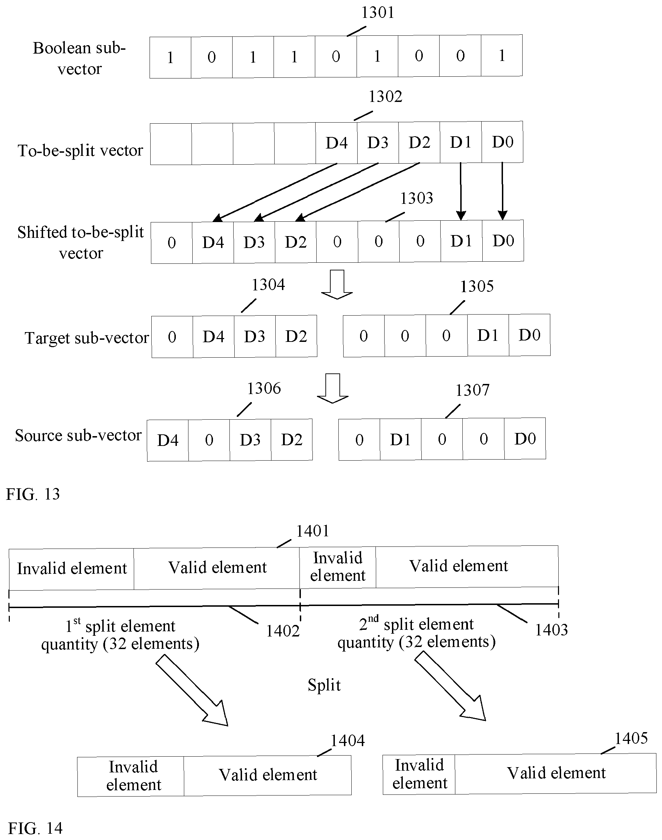

For example, referring to FIG. 13, in descending order of bits, the 1^{st} split element quantity is 4, and the 2^{nd} split element quantity is 5. The last valid split element corresponding to the 1^{st} split element quantity is located at the 7^{th} position of a to-be-split vector 1302. The last split element corresponding to the 1^{st} split element quantity is located at the 4^{th} position of a boolean sub-vector 1301. Therefore, a quantity of target to-be-shifted bits corresponding to the 1^{st} split element quantity may be: 7-4=3.

Optionally, in a case that the to-be-split vector corresponds to only 2 split element quantities, the valid split element quantity corresponding to the 1^{st} split element quantity may be directly determined as the quantity of target to-be-shifted bits corresponding to the 1^{st} split element quantity. For example, referring to FIG. 13, the 1^{st} split element quantity is 4, and the 2^{nd} split element quantity is 5. Based on the boolean sub-vector 1301, it may be determined that the 1^{st} split element quantity corresponds to 3 valid split elements. In this case, the quantity of target to-be-shifted bits corresponding to the 1^{st} split element quantity is 3.

The first data splitting unit shifts valid split elements in the first to-be-split vector corresponding to the target split element quantity as a whole based on the quantity of target to-be-shifted bits corresponding to the target split element quantity, to obtain an intermediate first to-be-split vector. The first data splitting unit further shifts the intermediate first to-be-split vector based on quantities of target to-be-shifted bits respectively corresponding to remaining split element quantities, to obtain the shifted first to-be-split vector. The remaining split element quantities are split element quantities in the s split element quantities other than the target split element quantity.

Exemplarily, the position of the target valid split element corresponding to the target split element quantity in the first to-be-split vector and the position of the target split element corresponding to the target split element quantity in the boolean vector are both positions in descending order of bits. The integral shifting of the valid split elements in the first to-be-split vector corresponding to the target split element quantity based on the quantity of target to-be-shifted bits corresponding to the target split element quantity means that the valid split elements in the first to-be-split vector corresponding to the target split element quantity are shifted toward a high bit as a whole by the quantity of target to-be-shifted bits.

For example, referring to FIG. 13, based on the foregoing embodiments, 3 valid split elements (D4, D3, and D2) corresponding to the 1^{st} split element quantity may be directly shifted toward a high bit by 3 bits in the to-be-split vector 1302, to obtain a shifted to-be-split vector 1303.

4. The first data splitting unit splits the shifted first to-be-split vector based on the s split element quantities, to obtain s split vectors corresponding to the first to-be-split vector.

Optionally, the s split vectors include a target split vector corresponding to the target split element quantity in the s split element quantities. The first data splitting unit determines a region corresponding to the target split vector corresponding to the target split element quantity in the boolean vector based on the target split element quantity. The first data splitting unit determines a target region corresponding to the target split vector in the shifted first to-be-split vector based on the region corresponding to the target split vector in the boolean vector. The first data splitting unit determines an element in the target region as an element of the target split vector. The target split vector is a split vector obtained through splitting of the shifted first to-be-split vector based on the target split element quantity.

For example, referring to FIG. 14, for a shifted first to-be-split vector 1401, the first data splitting unit determines a region corresponding to the 1^{st} split element quantity in the boolean vector based on the 1^{st} split element quantity, and then determines a target region 1402 corresponding to the 1^{st} split element quantity in a shifted first to-be-split vector 1401 based on the region corresponding to the 1^{st} split element quantity in the boolean vector, and may directly determine an element in the target region 1402 as an element corresponding to the 1^{st} split vector 1404. Similarly, an element in a target region 1403 corresponding to the 2^{nd} split element quantity in the shifted first to-be-split vector 1401 may be determined as an element corresponding to the 2^{nd} split vector 1405.

Optionally, the shifting method in this embodiment of this application is the same as that described in the foregoing embodiment. For content not described in this embodiment of this application, refer to the foregoing embodiments, and the details are not described herein.

Step 1103: The n sets of multiplexers respectively decompress the n target sub-vectors, to obtain n source sub-vectors, the n source sub-vectors being configured to be combined to obtain source vector data.

Optionally, for a t^{th} target sub-vector in n target sub-vectors, a t^{th} set of multiplexers corresponding to the t^{th} target sub-vector determine a valid element position distribution corresponding to the t^{th} target sub-vector based on the boolean vector corresponding to the target vector data, t being a positive integer less than or equal to n. The t^{th} set of multiplexers successively arrange valid elements in the t^{th} target sub-vector to a position corresponding to the valid element position distribution in descending order of bits, to obtain a t^{th} source sub-vector corresponding to the t^{th} target sub-vector.

For example, referring to FIG. 13, a target sub-vector 1304 and a target sub-vector 1305 may be obtained through splitting of the shifted to-be-split vector 1303. A valid element position distribution in a source sub-vector 1306 corresponding to the target sub-vector 1304 may be determined based on the boolean sub-vector 1301. In addition, the source sub-vector 1306 may be obtained through successive adjustment of the valid elements in descending order of bits based on the valid element position distribution. Similarly, a source sub-vector 1307 corresponding to the target sub-vector 1305 may be obtained.

Optionally, the n source sub-vectors may be obtained through decompression of the n target sub-vectors by the n sets of multiplexers in sequence.

Optionally, the n source sub-vectors may be obtained through decompression of the n target sub-vectors by the n sets of multiplexers in parallel. In this way, efficiency of obtaining the n source sub-vectors can be further improved, thereby improving decompression efficiency of the vector data.

Optionally, after the n source sub-vectors are obtained, the n source sub-vectors may be combined to obtain source vector data. For example, referring to FIG. 12, n source sub-vectors corresponding to target vector data 1202 may be combined based on a boolean vector 1201 to obtain source vector data 1203.

Optionally, the hardware resources used during the implementation of the data compression instruction are similar to the hardware resources used during the implementation of the data decompression instruction. In an actual implementation, these resources (such as the multiplexers and the shifter) may be reused to further reduce the area of the processor.

In summary, in the technical resolutions provided in this embodiment of this application, divide-and-conquer decompression of the target vector data is realized. Therefore, a plurality of multiplexers with a high parallelism degree are not required, a quantity of access ports of the multiplexers can be reduced, and a quantity of multiplexers to which the output ports of the target vector register need to be connected is reduced, thereby reducing a quantity of wires required for vector data decompression in the processor and wire intersections are reduced, significantly reducing a congestion level of the wires required for vector data decompression in the processor, and significantly reducing an area of the processor, especially an area of a processor with a high vector processing parallelism degree. The reduction of the area of the processor reduces manufacturing difficulty and manufacturing costs of the processor.

In addition, through the divide-and-conquer decompression of the target vector data, a decompression delay of the target vector data is reduced, thereby improving decompression efficiency of the target vector data.

An apparatus embodiment of this application is described below, which may be used for performing the method embodiment of this application. For details not disclosed in the apparatus embodiment of this application, refer to the foregoing embodiments of this application.

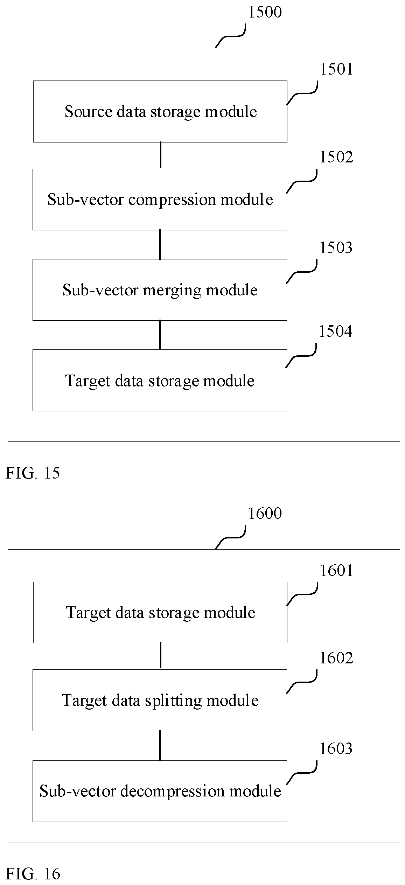

FIG. 15 is a block diagram of an apparatus for compressing vector data according to an embodiment of this application. The apparatus has a function of implementing the foregoing method. The function may be implemented by hardware or by executing corresponding software by hardware. The apparatus may be the computer device described above, or may be arranged in the computer device. As shown in FIG. 15, the apparatus 1500 includes: a source data storage module 1501, a sub-vector compression module 1502, a sub-vector merging module 1503, and a target data storage module 1504.

The source data storage module 1501 is configured to control a source vector register to store source vector data, the source vector data being divided into n source sub-vectors, the n source sub-vectors being in a one-to-one correspondence with n sets of multiplexers.

The sub-vector compression module 1502 is configured to control an i^{th} set of multiplexers in the n sets of multiplexers to selectively arrange valid elements in an i^{th} source sub-vector in the source vector data, to obtain an i^{th} target sub-vector corresponding to the i^{th} source sub-vector, valid elements in the i^{th} target sub-vector being located at a header of the i^{th} target sub-vector, and i being a positive integer less than or equal to n.

The sub-vector merging module 1503 is configured to control a data merging apparatus to shift and merge n target sub-vectors corresponding to the n source sub-vectors, to obtain target vector data, valid elements in the target vector data being located at a header of the target vector data.

The target data storage module 1504 is configured to control a target vector register to store the valid elements in the target vector data.

In an exemplary embodiment, the i^{th} source sub-vector includes x elements, the x elements including y valid elements, and the i^{th} set of multiplexers including x-1 multiplexers of different types, x being a positive integer, and y being a positive integer less than or equal to x-1.

The sub-vector compression module 1502 is configured to control y multiplexers in the x-1 multiplexers to select the y valid elements from the x elements in ascending order of bits based on a boolean vector corresponding to the source vector data, and arrange the y valid elements in ascending order of bits, to obtain the i^{th} target sub-vector, an element in the boolean vector being used for indicating a distribution of the valid elements in the source vector data.

In an exemplary embodiment, the sub-vector compression module 1502 is configured to: control a z^{th} multiplexer in the y multiplexers to select a z^{th} valid element from a z^{th} element to an x^{th} element in the i^{th} source sub-vector in ascending order of bits based on the boolean vector, z being a positive integer less than or equal to y; and control the z^{th} multiplexer to add the z^{th} valid element to a z^{th} position of the i^{th} target sub-vector.

In an exemplary embodiment, the data merging apparatus includes m sets of data merging units, the m sets of data merging units being configured to perform p rounds of shifting and merging on the n target sub-vectors to obtain the target vector data, m being an integer greater than 1, and p being a positive integer. The sub-vector merging module 1503 is configured to control, for a q^{th} round of shifting and merging, a q^{th} set of data merging units in the m sets of data merging units to shift and merge a q^{th} set of to-be-merged vectors, to obtain a q^{th} set of merged vectors, q being a positive integer less than or equal to p; and in a case that q is equal to 1, the q^{th} set of to-be-merged vectors being the n target sub-vectors, and in a case that q is greater than 1, the q^{th} set of to-be-merged vectors being a (q-1)^{th} set of merged vectors, and a p^{th} set of merged vectors being the target vector data.

In an exemplary embodiment, the sub-vector merging module 1503 is configured to control the data merging units in the q^{th} sets of data merging units to shift and merge each two adjacent to-be-merged vectors in the q^{th} set of to-be-merged vectors, to obtain the q^{th} set of merged vectors.

In an exemplary embodiment, the sub-vector merging module 1503 is further configured to control the data merging apparatus to add a target to-be-merged vector in the q^{th} set of to-be-merged vectors to the q^{th} set of merged vectors in a case that a quantity of data merging units in the q^{th} set of data merging units is an odd number, the target to-be-merged vector in the q^{th} set of to-be-merged vectors being the first to-be-merged vector or the last to-be-merged vector in the q^{th} set of to-be-merged vectors in ascending order of bits.

In an exemplary embodiment, in a case that the first data merging unit in the q^{th} set of data merging units shifts and merges the first to-be-merged vector and the second to-be-merged vector in the q^{th} set of to-be-merged vectors, the sub-vector merging module 1503 is configured to: control the first data merging unit to shift the first to-be-merged vector based on the second to-be-merged vector, to obtain an adjusted first to-be-merged vector; and control the first data merging unit to merge the adjusted first to-be-merged vector and the second to-be-merged vector, to obtain a first merged vector corresponding to the q^{th} set of merged vectors, an element corresponding to the second to-be-merged vector in the source vector data being at a lower bit than an element corresponding to the first to-be-merged vector in the source vector data.

In an exemplary embodiment, the sub-vector merging module 1503 is configured to: control the first data merging unit to fill the first to-be-merged vector with elements based on a quantity of elements in the second to-be-merged vector, to obtain a filled first to-be-merged vector, a quantity of elements in the filled first to-be-merged vector being a sum of the quantity of the elements in the second to-be-merged vector and a quantity of elements in the first to-be-merged vector; and control the first data merging unit to shift non-filling elements in the filled first to-be-merged vector as a whole based on a quantity of invalid elements in the second to-be-merged vector, to obtain the adjusted first to-be-merged vector, a quantity of non-filling elements corresponding to a header of the adjusted first to-be-merged vector being the same as the quantity of the valid elements in the second to-be-merged vector.

In an exemplary embodiment, the sub-vector merging module 1503 is configured to: control the first data merging unit to select elements corresponding to the first merged vector from the adjusted first to-be-merged vector and the second to-be-merged vector in ascending order of bits; and control, for a k^{th} element corresponding to the first merged vector, the first data merging unit to select one of a k^{th} element in the adjusted first to-be-merged vector and a k^{th} element in the second to-be-merged vector as the k^{th} element corresponding to the first merged vector, k being a positive integer.

In an exemplary embodiment, the sub-vector merging module 1503 is configured to: control the first data merging unit to determine the k^{th} element in the adjusted first to-be-merged vector as the k^{th} element corresponding to the first merged vector in a case that the k^{th} element in the adjusted first to-be-merged vector is a valid element; or control the first data merging unit to determine the k^{th} element in the second to-be-merged vector as the k^{th} element corresponding to the first merged vector in a case that the k^{th} element in the second to-be-merged vector is a valid element.

In an exemplary embodiment, the n target sub-vectors are obtained through selective arrangement of valid elements of the n source sub-vectors performed by the n sets of multiplexers in parallel.

In summary, in the technical resolutions provided in the embodiments of this application, the n source sub-vectors divided from the source vector data are compressed respectively by using the n sets of multiplexers, to obtain the n target sub-vectors. Then, the n target sub-vectors are shifted and merged to obtain target vector data, that is, compressed source vector data. In this way, divide-and-conquer processing of vector data is implemented. Therefore, a plurality of multiplexers with a high parallelism degree are not required, a quantity of access ports of the multiplexers can be reduced, and a quantity of multiplexers to which the output ports of the source vector register need to be connected is reduced, thereby reducing a quantity of wires required for vector data compression in the processor and wire intersections are reduced, significantly reducing a congestion level of the wires required for vector data compression in the processor, and significantly reducing an area of the processor, especially an area of a processor with a high vector processing parallelism degree. The reduction of the area of the processor reduces manufacturing difficulty and manufacturing costs of the processor.

In addition, since the n source sub-vectors are compressed respectively by using the n sets of multiplexers, a compression delay of the vector data is reduced, and compression efficiency of the vector data is improved.

FIG. 16 is a block diagram of an apparatus for decompressing vector data according to an embodiment of this application. The apparatus has a function of implementing the foregoing method. The function may be implemented by hardware or by executing corresponding software by hardware. The apparatus may be the computer device described above, or may be arranged in the computer device. As shown in FIG. 16, the apparatus 1600 includes a target data storage module 1601, a target data splitting module 1602, and a sub-vector decompression module 1603.

The target data storage module 1601 is configured to control a target vector register to store target vector data, valid elements in the target vector data being located at a header of the target vector data.

The target data splitting module 1602 is configured to control a data splitting apparatus to shift and split the target vector data, to obtain n target sub-vectors, valid elements in each of the target sub-vectors being located at a header of the target sub-vector.

The sub-vector decompression module 1603 is configured to control n sets of multiplexers to respectively decompress the n target sub-vectors, to obtain n source sub-vectors, the n source sub-vectors being configured to be combined to obtain source vector data.

In an exemplary embodiment, the data splitting apparatus includes m sets of data splitting units, the m sets of data splitting units being configured to perform p rounds of shifting and splitting on the target vector data to obtain the n target sub-vectors, m being an integer greater than 1, and p being a positive integer.

The target data splitting module 1602 is configured to control, for a q^{th} round of shifting and splitting, a q^{th} set of data splitting units in the m sets of data splitting units to shift and split a q^{th} set of to-be-split vectors, to obtain a q^{th} set of split vectors, q being a positive integer less than or equal to p; and in a case that q is equal to 1, the q^{th} set of to-be-split vectors being the target vector data, and in a case that q is greater than 1, the q^{th} set of to-be-split vectors being a (q-1)^{th} set of split vectors, and a p^{th} set of split vectors being the n target sub-vectors.

In an exemplary embodiment, the q^{th} set of split vectors include s split vectors corresponding to a first to-be-split vector in the q^{th} set of to-be-split vectors, s being an integer greater than 1. In a case that a first data splitting unit in the q^{th} set of data splitting units shifts and splits the first to-be-split vector, the target data splitting module 1602 is configured to: control the first data splitting unit to determine s split element quantities corresponding to the first to-be-split vector; control the first data splitting unit to determine s sets of valid split elements based on a boolean vector corresponding to the target vector data and the s split element quantities, an element in the boolean vector being used for indicating a distribution of the valid elements in the source vector data; control the first data splitting unit in the first to-be-split vector to respectively shift the s sets of valid split elements as a whole in the first to-be-split vector based on the s sets of valid split elements, to obtain a shifted first to-be-split vector; and control the first data splitting unit to split the shifted first to-be-split vector based on the s split element quantities, to obtain s split vectors corresponding to the first to-be-split vector.

In an exemplary embodiment, the target data splitting module 1602 is configured to: control, for a target split element quantity in the s split element quantities, the first data splitting unit to determine a quantity of target to-be-shifted bits based on a difference between a position of a target valid split element corresponding to the target split element quantity in the first to-be-split vector and a position of a target split element corresponding to the target split element quantity in the boolean vector, the target valid split element corresponding to the target split element quantity being the last valid split element corresponding to the target split element quantity in descending order of bits, and the target split element corresponding to the target split element quantity being the last split element corresponding to the target split element quantity in descending order of bits; control the first data splitting unit to shift valid split elements in the first to-be-split vector corresponding to the target split element quantity as a whole based on the quantity of target to-be-shifted bits, to obtain an intermediate first to-be-split vector; and control the first data splitting unit to further shift the intermediate first to-be-split vector based on quantities of target to-be-shifted bits respectively corresponding to remaining split element quantities, to obtain the shifted first to-be-split vector.

In an exemplary embodiment, the s split vectors include a target split vector corresponding to a target split element quantity in the s split element quantities. The target data splitting module 1602 is configured to: control the first data splitting unit to determine a region corresponding to the target split vector corresponding to the target split element quantity in the boolean vector based on the target split element quantity; control the first data splitting unit to determine a target region corresponding to the target split vector in the shifted first to-be-split vector based on the region corresponding to the target split vector in the boolean vector; and control the first data splitting unit to determine an element in the target region as an element of the target split vector.

In an exemplary embodiment, the sub-vector decompression module 1603 is configured to: control, for a t^{th} target sub-vector in the n target sub-vectors, a t^{th} set of multiplexers in the n sets of multiplexers corresponding to the t^{th} target sub-vector to determine a valid element position distribution corresponding to the t^{th} target sub-vector based on the boolean vector corresponding to the target vector data, t being a positive integer less than or equal to n; and control the t^{th} set of multiplexers to successively arrange valid elements in the t^{th} target sub-vector to a position corresponding to the valid element position distribution in descending order of bits, to obtain a t^{th} source sub-vector corresponding to the t^{th} target sub-vector.

In an exemplary embodiment, the n source sub-vectors are obtained through decompression of the n target sub-vectors by the n sets of multiplexers in parallel.

In summary, in the technical resolutions provided in this embodiment of this application, divide-and-conquer decompression of the target vector data is realized. Therefore, a plurality of multiplexers with a high parallelism degree are not required, a quantity of access ports of the multiplexers can be reduced, and a quantity of multiplexers to which the output ports of the target vector register need to be connected is reduced, thereby reducing a quantity of wires (for example) required for vector data decompression in the processor and wire intersections (for example, relative to) are reduced, significantly reducing a congestion level of the wires required for vector data decompression in the processor, and significantly reducing an area of the processor, especially an area of a processor with a high vector processing parallelism degree. The reduction of the area of the processor reduces manufacturing difficulty and manufacturing costs of the processor.

In addition, through the divide-and-conquer decompression of the target vector data, a decompression delay of the target vector data is reduced, thereby improving decompression efficiency of the target vector data.

It is to be understood that, during function implementation of the apparatus provided in the foregoing embodiment, only division of the functional modules is illustrated. In actual application, the functions may be assigned to different functional modules for completion as required. In other words, an internal structure of the device is divided into different functional modules to complete all or some of the functions described above. In addition, the apparatus in the foregoing embodiment belongs to the same idea as the method. For a specific implementation thereof, refer to the method embodiment, and the details are not described herein.

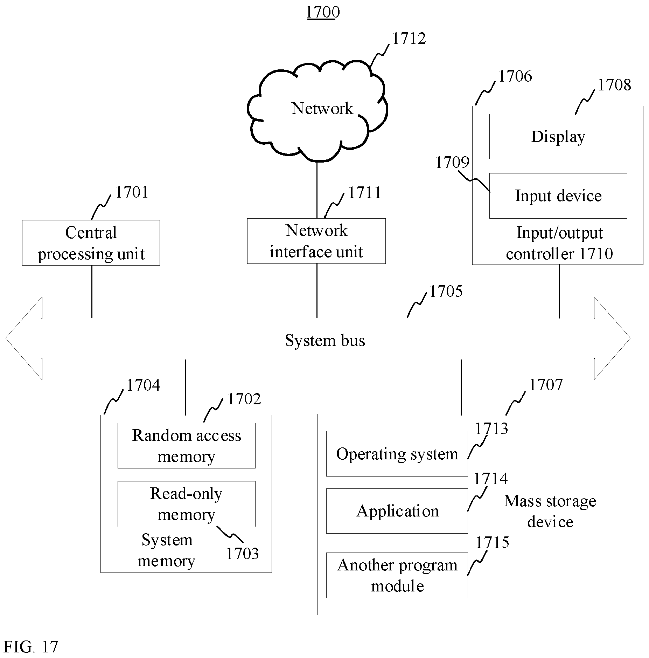

FIG. 17 is a structural block diagram of a computer device according to an embodiment of this application. The computer device may be configured to implement the method for compressing vector data or the method for decompressing vector data provided in the foregoing embodiments. Details may be as follows:

The computer device 1700 includes a central processing unit (CPU), a graphics processing unit (GPU), a field programmable gate array (FPGA) 1701, a system memory 1704 including a random access memory (RAM) 1702 and a read-only memory (ROM) 1703, and a system bus 1705 connecting the system memory 1704 and the CPU 1701. The computer device 1700 further includes a basic input/output system (I/O system) 1706 assisting information transmission between devices in a server, and a mass storage device 1707 configured to store an operating system 1713, an application 1714, and another program module 1715.

The basic input/output system 1706 includes a display 1708 configured to display information and an input device 1709, such as a mouse or a keyboard for a user to input information. The display 1708 and the input device 1709 are both connected to the CPU 1701 through an input/output controller 1710 connected to the system bus 1705. The basic input/output system 1706 may further include the input/output system controller 1710 for receiving and processing an input from a plurality of other devices such as a keyboard, a mouse, or an electronic stylus. Similarly, the input/output controller 1710 further provides an output to a display screen, a printer, or another type of output device.

The mass storage device 1707 is connected to the CPU 1701 through a mass storage controller (not shown) connected to the system bus 1705. The mass storage device 1707 and an associated computer-readable medium thereof provide non-volatile storage for the computer device 1700. In other words, the mass storage device 1707 may include a computer-readable medium (not shown) such as a hard disk or a compact disc read-only memory (CD-ROM) drive.

Without loss of generality, the computer-readable medium may include a computer storage medium and a communication medium. The computer storage medium includes volatile and non-volatile media, and removable and non-removable media implemented by using any method or technology used for storing information such as computer-readable instructions, data structures, program modules, or other data. The computer storage medium includes a RAM, a ROM, an erasable programmable read-only memory (EPROM), an electrically erasable programmable ROM (EEPROM), a flash memory or another solid-state storage technology, a CD-ROM, a digital versatile disc (DVD) or another optical memory, a tape cartridge, a magnetic cassette, a magnetic disk memory, or another magnetic storage device. Certainly, a person skilled in the art may learn that the computer storage medium is not limited to the above. The foregoing system memory 1704 and mass storage device 1707 may be collectively referred to as a memory.

According to the embodiments of this application, the computer device 1700 may be further connected to a remote computer on a network for running through a network such as the Internet. In other words, the computer device 1700 may be connected to a network 1712 through a network interface unit 1711 connected to the system bus 1705, or may be connected to another type of network or remote computer system (not shown) through the network interface unit 1711.

The memory further includes at least one instruction, at least one program, a code set or an instruction set. The at least one instruction, the at least one program, the code set, or the instruction set is stored in the memory and is configured to be executed by a processor to cause a computer device to implement the foregoing method for compressing vector data or the foregoing method for decompressing vector data.

In an exemplary embodiment, a non-volatile computer-readable storage medium is further provided. The non-volatile computer-readable storage medium stores at least one instruction, at least one program, a code set, or an instruction set. The at least one instruction, the at least one program, the code set, or the instruction set, when executed by a processor, causes a computer to implement the foregoing method for compressing vector data or the foregoing method for decompressing vector data.

Optionally, the non-volatile computer-readable storage medium may include a ROM, a RAM, a solid state drive (SSD), an optical disc, or the like. The RAM may include a resistance random access memory (ReRAM) and a dynamic random access memory (DRAM).

In an exemplary embodiment, a computer program product or a computer program is further provided. The computer program product or the computer program includes computer instructions. The computer instructions are stored in a non-volatile computer-readable storage medium. A processor of a computer device reads the computer instructions from the non-volatile computer-readable storage medium, and executes the computer instructions to cause the computer device to perform the foregoing method for compressing vector data or the foregoing method for decompressing vector data.

The information (including but not limited to device information of an object and personal information of an object), data (including but not limited to data used for analysis, stored data, and displayed data), and signals in this application are all authorized by the object or fully authorized by all parties, and collection, use, and processing of relevant data need to comply with relevant laws, regulations, and standards of relevant countries and regions. For example, the wiring manner, the hardware architecture of the processor, and the like in this application are obtained after full authorization.

It is to be understood that the term "a plurality of" mentioned herein means two or more. "And/or" describes an association relationship between associated objects and indicates that three relationships may exist. For example, A and/or B may represent the following three cases: Only A exists, both A and B exist, and only B exists. The character "/" generally indicates an "or" relationship between the associated objects. In addition, the step numbers described herein merely exemplarily show a possible execution sequence of the steps. In some other embodiments, the steps may not be performed according to the number sequence. For example, two steps with different numbers may be performed simultaneously, or two steps with different numbers may be performed according to a sequence reverse to the sequence shown in the figure. This is not limited in the embodiments of this application.

The foregoing descriptions are merely exemplary embodiments of this application, and are not intended to limit this application. The scope for protection is defined by the appended claims.

## Claims

1. A method for compressing vector data, the method being performed by a processor (200), **characterized in that** the processor (200) comprises a source vector register (201), n sets of multiplexers, a data merging apparatus (202), and a target vector register (203), n being an integer greater than 1; and
the method comprising:
storing, by the source vector register (201), source vector data, the source vector data being divided into n source sub-vectors, the n source sub-vectors being in a one-to-one correspondence with the n sets of multiplexers (401);
selectively arranging, by an i^{th} set of multiplexers in the n sets of multiplexers, valid elements in an i^{th} source sub-vector in the source vector data, to obtain an i^{th} target sub-vector corresponding to the i^{th} source sub-vector, valid elements in the i^{th} target sub-vector being located at a header of the i^{th} target sub-vector, and i being a positive integer less than or equal to n, and an element in a boolean vector corresponding to the source vector data being used for indicating a distribution of the valid elements in the source vector data (402);
shifting and merging, by the data merging apparatus (202), n target sub-vectors corresponding to the n source sub-vectors, to obtain target vector data, valid elements in the target vector data being located at a header of the target vector data (403); and
storing, by the target vector register (203), the valid elements in the target vector data (404).

2. The method according to claim 1, wherein the i^{th} source sub-vector comprises x elements, the x elements comprising y valid elements, and the i^{th} set of multiplexers comprising x-1 multiplexers of different types, x being a positive integer, and y being a positive integer less than or equal to x-1; and
the selectively arranging, by an i^{th} set of multiplexers in the n sets of multiplexers, valid elements in an i^{th} source sub-vector in the source vector data, to obtain an i^{th} target sub-vector corresponding to the i^{th} source sub-vector comprises:
selecting, by y multiplexers in the x-1 multiplexers, the y valid elements from the x elements in ascending order of bits based on the boolean vector corresponding to the source vector data, and arranging the y valid elements in ascending order of bits, to obtain the i^{th} target sub-vector.

3. The method according to claim 2, wherein the selecting, by y multiplexers in the x-1 multiplexers, the y valid elements from the x elements in ascending order of bits based on a boolean vector corresponding to the source vector data, and arranging the y valid elements in ascending order of bits, to obtain the i^{th} target sub-vector comprises:
selecting, by a z^{th} multiplexer in the y multiplexers, a z^{th} valid element from a z^{th} element to an x^{th} element in the i^{th} source sub-vector in ascending order of bits based on the boolean vector, z being a positive integer less than or equal to y; and
adding, by the z^{th} multiplexer, the z^{th} valid element to a z^{th} position of the i^{th} target sub-vector.

4. The method according to claim 1, wherein the data merging apparatus (202) comprises m sets of data merging units, the m sets of data merging units being configured to perform p rounds of shifting and merging on the n target sub-vectors to obtain the target vector data, m being an integer greater than 1, and p being a positive integer; and
the shifting and merging, by the data merging apparatus (202), n target sub-vectors corresponding to the n source sub-vectors, to obtain target vector data comprise:
shifting and merging, by a q^{th} set of data merging units in the m sets of data merging units for a q^{th} round of shifting and merging, a q^{th} set of to-be-merged vectors, to obtain a q^{th} set of merged vectors, q being a positive integer less than or equal to p; and
in a case that q is equal to 1, the q^{th} set of to-be-merged vectors being the n target sub-vectors, and in a case that q is greater than 1, the q^{th} set of to-be-merged vectors being a (q-1)^{th} set of merged vectors, and a p^{th} set of merged vectors being the target vector data.

5. The method according to claim 4, wherein the shifting and merging, by a q^{th} set of data merging units in the m sets of data merging units, a q^{th} set of to-be-merged vectors, to obtain a q^{th} set of merged vectors comprise:
shifting and merging, by the data merging units in the q^{th} set of data merging units, each two adjacent to-be-merged vectors in the q^{th} set of to-be-merged vectors, to obtain the q^{th} set of merged vectors.

6. The method according to claim 5, wherein in a case that a first data merging unit in the q^{th} set of data merging units shifts and merges a first to-be-merged vector and a second to-be-merged vector in the q^{th} set of to-be-merged vectors, the shifting and merging, by the data merging units in the q^{th} set of data merging units, each two adjacent to-be-merged vectors in the q^{th} set of to-be-merged vectors, to obtain the q^{th} set of merged vectors comprise:
shifting, by the first data merging unit, the first to-be-merged vector based on the second to-be-merged vector, to obtain an adjusted first to-be-merged vector; and
merging, by the first data merging unit, the adjusted first to-be-merged vector and the second to-be-merged vector, to obtain a first merged vector corresponding to the q^{th} set of merged vectors,
an element corresponding to the second to-be-merged vector in the source vector data being at a lower bit than an element corresponding to the first to-be-merged vector in the source vector data.

7. The method according to claim 6, wherein the shifting, by the first data merging unit, the first to-be-merged vector based on the second to-be-merged vector, to obtain an adjusted first to-be-merged vector comprises:
filling, by the first data merging unit, the first to-be-merged vector with elements based on a quantity of elements in the second to-be-merged vector, to obtain a filled first to-be-merged vector, a quantity of elements in the filled first to-be-merged vector being a sum of the quantity of the elements in the second to-be-merged vector and a quantity of elements in the first to-be-merged vector; and
shifting, by the first data merging unit, non-filling elements in the filled first to-be-merged vector as a whole based on a quantity of invalid elements in the second to-be-merged vector, to obtain the adjusted first to-be-merged vector, a quantity of non-filling elements corresponding to a header of the adjusted first to-be-merged vector being the same as the quantity of the valid elements in the second to-be-merged vector.

8. The method according to claim 6, wherein the merging, by the first data merging unit, the adjusted first to-be-merged vector and the second to-be-merged vector, to obtain a first merged vector corresponding to the q^{th} set of merged vectors comprises:
selecting, by the first data merging unit, elements corresponding to the first merged vector from the adjusted first to-be-merged vector and the second to-be-merged vector in ascending order of bits; and
selecting, by the first data merging unit for a k^{th} element corresponding to the first merged vector, one of a k^{th} element in the adjusted first to-be-merged vector and a k^{th} element in the second to-be-merged vector as the k^{th} element corresponding to the first merged vector, k being a positive integer.

9. The method according to claim 8, wherein the selecting, by the first data merging unit, one of a k^{th} element in the adjusted first to-be-merged vector and a k^{th} element in the second to-be-merged vector as the k^{th} element corresponding to the first merged vector comprises:
determining, by the first data merging unit, the k^{th} element in the adjusted first to-be-merged vector as the k^{th} element corresponding to the first merged vector in a case that the k^{th} element in the adjusted first to-be-merged vector is a valid element;
or
determining, by the first data merging unit, the k^{th} element in the second to-be-merged vector as the k^{th} element corresponding to the first merged vector in a case that the k^{th} element in the second to-be-merged vector is a valid element.

10. A method for decompressing vector data obtained by the method according claim 1, the method being performed by a processor (900), **characterized in that** the processor (900) comprises a target vector register (901), a data splitting apparatus (902), and n sets of multiplexers, n being an integer greater than 1; and
the method comprising:
storing, by the target vector register (901), target vector data, valid elements in the target vector data being located at a header of the target vector data , and an element in a boolean vector corresponding to the source vector data being used for indicating a distribution of the valid elements in the source vector data (1101);
shifting and splitting, by the data splitting apparatus (902), the target vector data, to obtain n target sub-vectors, valid elements in each of the target sub-vectors being located at a header of the target sub-vector (1102); and
respectively decompressing, by the n sets of multiplexers, the n target sub-vectors, to obtain n source sub-vectors, the n source sub-vectors being configured to be combined to obtain source vector data based on the boolean vector (1103);
wherein the data splitting apparatus (902) comprises m sets of data splitting units, the m sets of data splitting units being configured to perform p rounds of shifting and splitting on the target vector data to obtain the n target sub-vectors, m being an integer greater than 1, and p being a positive integer; and
the shifting and splitting, by the data splitting apparatus (902), the target vector data, to obtain n target sub-vectors comprise:
shifting and splitting, by a q^{th} set of data splitting units in the m sets of data splitting units for a q^{th} round of shifting and splitting, a q^{th} set of to-be-split vectors, to obtain a q^{th} set of split vectors, q being a positive integer less than or equal to p; and
in a case that q is equal to 1, the q^{th} set of to-be-split vectors being the target vector data, and in a case that q is greater than 1, the q^{th} set of to-be-split vectors being a (q-1)^{th} set of split vectors, and a p^{th} set of split vectors being the n target sub-vectors.

11. The method according to claim 10, wherein the q^{th} set of split vectors comprise s split vectors corresponding to a first to-be-split vector in the q^{th} set of to-be-split vectors, s being an integer greater than 1; and
in a case that a first data splitting unit in the q^{th} set of data splitting units shifts and splits the first to-be-split vector, the s split vectors corresponding to the first to-be-split vector are obtained in the following manner:
determining, by the first data splitting unit, s split element quantities corresponding to the first to-be-split vector;
determining, by the first data splitting unit, s sets of valid split elements based on the boolean vector corresponding to the target vector data and the s split element quantities;
respectively shifting, by the first data splitting unit, the s sets of valid split elements as a whole in the first to-be-split vector based on the s sets of valid split elements, to obtain a shifted first to-be-split vector; and
splitting, by the first data splitting unit, the shifted first to-be-split vector based on the s split element quantities, to obtain s split vectors corresponding to the first to-be-split vector.

12. The method according to claim 11, wherein the respectively shifting, by the first data splitting unit, the s sets of valid split elements as a whole in the first to-be-split vector based on the s sets of valid split elements, to obtain a shifted first to-be-split vector comprises:
determining, by the first data splitting unit for a target split element quantity in the s split element quantities, a quantity of target to-be-shifted bits corresponding to the target split element quantity based on a difference between a position of a target valid split element corresponding to the target split element quantity in the first to-be-split vector and a position of the target split element corresponding to the target split element quantity in the boolean vector;
shifting, by the first data splitting unit, valid split elements in the first to-be-split vector corresponding to the target split element quantity as a whole based on the quantity of target to-be-shifted bits corresponding to the target split element quantity, to obtain an intermediate first to-be-split vector; and further shifting, by the first data splitting unit, the intermediate first to-be-split vector based on quantities of target to-be-shifted bits respectively corresponding to remaining split element quantities, to obtain the shifted first to-be-split vector,
the target valid split element corresponding to the target split element quantity being the last valid split element corresponding to the target split element quantity in descending order of bits, and the target split element corresponding to the target split element quantity being the last split element corresponding to the target split element quantity in descending order of bits.

13. The method according to claim 11, wherein the s split vectors comprise a target split vector corresponding to a target split element quantity in the s split element quantities; and
the splitting, by the first data splitting unit, the shifted first to-be-split vector based on the s split element quantities, to obtain the s split vectors corresponding to the first to-be-split vector comprises:
determining, by the first data splitting unit, a region corresponding to the target split vector corresponding to the target split element quantity in the boolean vector based on the target split element quantity;
determining, by the first data splitting unit, a target region corresponding to the target split vector in the shifted first to-be-split vector based on the region corresponding to the target split vector in the boolean vector; and
determining, by the first data splitting unit, an element in the target region as an element of the target split vector.

14. A computer device, comprising a processor and a memory, the memory storing at least one instruction, at least one program, a code set, or an instruction set, the at least one instruction, the at least one program, the code set, or the instruction set being loaded and executed by the processor to cause the computer device to implement the method for compressing vector data according to any one of claims 1 to 9, or implement the method for decompressing vector data according to any one of claims 10 to 13.

15. A non-volatile computer-readable storage medium, storing at least one instruction, at least one program, a code set, or an instruction set, the at least one instruction, the at least one program, the code set, or the instruction set being loaded and executed by a processor to cause a computer to implement the method for compressing vector data according to any one of claims 1 to 9 or implement the method for decompressing vector data according to any one of claims 10 to 13.

## Patentansprüche

1. Verfahren zum Komprimieren von Vektordaten, wobei das Verfahren durch einen Prozessor (200) durchgeführt wird, **dadurch gekennzeichnet, dass** der Prozessor (200) ein Quellvektorregister (201), n Sätze von Multiplexern, eine Datenzusammenführungsvorrichtung (202) und ein Zielvektorregister (203) umfasst, wobei n eine ganze Zahl größer als 1 ist; und
wobei das Verfahren umfasst:
Speichern, durch das Quellvektorregister (201), von Quellvektordaten, wobei die Quellvektordaten in n Quell-Teilvektoren unterteilt sind, wobei die n Quell-Teilvektoren in einer Eins-zu-eins-Entsprechung mit den n Sätzen von Multiplexern (401) sind;
selektives Anordnen, durch einen i-ten Satz von Multiplexern in den n Sätzen von Multiplexern, von gültigen Elementen in einem i-ten Quell-Teilvektor in den Quellvektordaten, um einen i-ten Ziel-Teilvektor zu erhalten, der dem i-ten Quell-Teilvektor entspricht, wobei gültige Elemente in dem i-ten Ziel-Teilvektor an einem Kopf des i-ten Ziel-Teilvektors angeordnet sind, und wobei i eine positive ganze Zahl kleiner oder gleich n ist, und wobei ein Element in einem booleschen Vektor, der den Quellvektordaten entspricht, zum Anzeigen einer Verteilung der gültigen Elemente in den Quellvektordaten verwendet wird (402);
Verschieben und Zusammenführen, durch die Datenzusammenführungsvorrichtung (202), von n Ziel-Teilvektoren, die den n Quell-Teilvektoren entsprechen, um Zielvektordaten zu erhalten, wobei gültige Elemente in den Zielvektordaten an einem Kopf der Zielvektordaten angeordnet sind (403); und
Speichern, durch das Zielvektorregister (203), der gültigen Elemente in den Zielvektordaten (404).

2. Verfahren nach Anspruch 1, wobei der i-te Quell-Teilvektor x Elemente umfasst, wobei die x Elemente y gültige Elemente umfassen, und wobei der i-te Satz von Multiplexern x-1 Multiplexer verschiedener Typen umfasst, wobei x eine positive ganze Zahl ist, und wobei y eine positive ganze Zahl kleiner oder gleich x-1 ist; und
wobei das selektive Anordnen, durch einen i-ten Satz von Multiplexern in den n Sätzen von Multiplexern, von gültigen Elementen in einem i-ten Quell-Teilvektor in den Quellvektordaten, um einen i-ten Ziel-Teilvektor zu erhalten, der dem i-ten Quell-Teilvektor entspricht, umfasst:
Auswählen, durch y Multiplexer in den x-1 Multiplexern, der y gültigen Elemente aus den x Elementen in aufsteigender Bitreihenfolge basierend auf dem booleschen Vektor, der den Quellvektordaten entspricht, und Anordnen der y gültigen Elemente in aufsteigender Bitreihenfolge, um den i-ten Ziel-Teilvektor zu erhalten.

3. Verfahren nach Anspruch 2, wobei das Auswählen, durch y Multiplexer in den x-1 Multiplexern, der y gültigen Elemente aus den x Elementen in aufsteigender Bitreihenfolge basierend auf einem booleschen Vektor, der den Quellvektordaten entspricht, und Anordnen der y gültigen Elemente in aufsteigender Bitreihenfolge, um den i-ten Ziel-Teilvektor zu erhalten, umfasst:
Auswählen, durch einen z-ten Multiplexer in den y Multiplexern, eines z-ten gültigen Elements aus einem z-ten Element bis zu einem x-ten Element in dem i-ten Quell-Teilvektor in aufsteigender Bitreihenfolge basierend auf dem booleschen Vektor, wobei z eine positive ganze Zahl kleiner oder gleich y ist; und
Hinzufügen, durch den z-ten Multiplexer, des z-ten gültigen Elements zu einer z-ten Position des i-ten Ziel-Teilvektors.

4. Verfahren nach Anspruch 1, wobei die Datenzusammenführungsvorrichtung (202) m Sätze von Datenzusammenführungseinheiten umfasst, wobei die m Sätze von Datenzusammenführungseinheiten konfiguriert sind, p Runden des Verschiebens und Zusammenführens an den n Ziel-Teilvektoren durchzuführen, um die Zielvektordaten zu erhalten, wobei m eine ganze Zahl größer als 1 ist, und wobei p eine positive ganze Zahl ist; und
wobei das Verschieben und Zusammenführen, durch die Datenzusammenführungsvorrichtung (202), von n Ziel-Teilvektoren, die den n Quell-Teilvektoren entsprechen, um Zielvektordaten zu erhalten, umfasst:
Verschieben und Zusammenführen, durch einen q-ten Satz von Datenzusammenführungseinheiten in den m Sätzen von Datenzusammenführungseinheiten für eine q-te Runde des Verschiebens und Zusammenführens, eines q-ten Satzes von zusammenzuführenden Vektoren, um einen q-ten Satz von zusammengeführten Vektoren zu erhalten, wobei q eine positive ganze Zahl kleiner oder gleich p ist; und
wobei in einem Fall, dass q gleich 1 ist, der q-te Satz von zusammenzuführenden Vektoren die n Ziel-Teilvektoren ist, und in einem Fall, dass q größer als 1 ist, der q-te Satz von zusammenzuführenden Vektoren ein (q-1)-ter Satz von zusammengeführten Vektoren ist, und wobei ein p-ter Satz von zusammengeführten Vektoren die Zielvektordaten ist.

5. Verfahren nach Anspruch 4, wobei das Verschieben und Zusammenführen, durch einen q-ten Satz von Datenzusammenführungseinheiten in den m Sätzen von Datenzusammenführungseinheiten, eines q-ten Satzes von zusammenzuführenden Vektoren, um einen q-ten Satz von zusammengeführten Vektoren zu erhalten, umfasst:
Verschieben und Zusammenführen, durch die Datenzusammenführungseinheiten in dem q-ten Satz von Datenzusammenführungseinheiten, von jeweils zwei benachbarten zusammenzuführenden Vektoren in dem q-ten Satz von zusammenzuführenden Vektoren, um den q-ten Satz von zusammengeführten Vektoren zu erhalten.

6. Verfahren nach Anspruch 5, wobei in einem Fall, dass eine erste Datenzusammenführungseinheit in dem q-ten Satz von Datenzusammenführungseinheiten einen ersten zusammenzuführenden Vektor und einen zweiten zusammenzuführenden Vektor in dem q-ten Satz von zusammenzuführenden Vektoren verschiebt und zusammenführt, das Verschieben und Zusammenführen, durch die Datenzusammenführungseinheiten in dem q-ten Satz von Datenzusammenführungseinheiten, von jeweils zwei benachbarten zusammenzuführenden Vektoren in dem q-ten Satz von zusammenzuführenden Vektoren, um den q-ten Satz von zusammengeführten Vektoren zu erhalten, umfasst:
Verschieben, durch die erste Datenzusammenführungseinheit, des ersten zusammenzuführenden Vektors basierend auf dem zweiten zusammenzuführenden Vektor, um einen angepassten ersten zusammenzuführenden Vektor zu erhalten; und
Zusammenführen, durch die erste Datenzusammenführungseinheit, des angepassten ersten zusammenzuführenden Vektors und des zweiten zusammenzuführenden Vektors, um einen ersten zusammengeführten Vektor zu erhalten, der dem q-ten Satz von zusammengeführten Vektoren entspricht,
wobei ein Element, das dem zweiten zusammenzuführenden Vektor in den Quellvektordaten entspricht, an einem niedrigeren Bit ist als ein Element, das dem ersten zusammenzuführenden Vektor in den Quellvektordaten entspricht.

7. Verfahren nach Anspruch 6, wobei das Verschieben, durch die erste Datenzusammenführungseinheit, des ersten zusammenzuführenden Vektors basierend auf dem zweiten zusammenzuführenden Vektor, um einen angepassten ersten zusammenzuführenden Vektor zu erhalten, umfasst:
Füllen, durch die erste Datenzusammenführungseinheit, des ersten zusammenzuführenden Vektors mit Elementen basierend auf einer Anzahl von Elementen in dem zweiten zusammenzuführenden Vektor, um einen gefüllten ersten zusammenzuführenden Vektor zu erhalten, wobei eine Anzahl von Elementen in dem gefüllten ersten zusammenzuführenden Vektor eine Summe der Anzahl der Elemente in dem zweiten zusammenzuführenden Vektor und einer Anzahl von Elementen in dem ersten zusammenzuführenden Vektor ist; und
Verschieben, durch die erste Datenzusammenführungseinheit, von Nicht-Füllelementen in dem gefüllten ersten zusammenzuführenden Vektor als Ganzes basierend auf einer Anzahl von ungültigen Elementen in dem zweiten zusammenzuführenden Vektor, um den angepassten ersten zusammenzuführenden Vektor zu erhalten, wobei eine Anzahl von Nicht-Füllelementen, die einem Kopf des angepassten ersten zusammenzuführenden Vektors entsprechen, dieselbe ist wie die Anzahl der gültigen Elemente in dem zweiten zusammenzuführenden Vektor.

8. Verfahren nach Anspruch 6, wobei das Zusammenführen, durch die erste Datenzusammenführungseinheit, des angepassten ersten zusammenzuführenden Vektors und des zweiten zusammenzuführenden Vektors, um einen ersten zusammengeführten Vektor zu erhalten, der dem q-ten Satz von zusammengeführten Vektoren entspricht, umfasst:
Auswählen, durch die erste Datenzusammenführungseinheit, von Elementen, die dem ersten zusammengeführten Vektor entsprechen, aus dem angepassten ersten zusammenzuführenden Vektor und dem zweiten zusammenzuführenden Vektor in aufsteigender Bitreihenfolge; und
Auswählen, durch die erste Datenzusammenführungseinheit für ein k-tes Element, das dem ersten zusammengeführten Vektor entspricht, eines von einem k-ten Element in dem angepassten ersten zusammenzuführenden Vektor und einem k-ten Element in dem zweiten zusammenzuführenden Vektor als das k-te Element, das dem ersten zusammengeführten Vektor entspricht, wobei k eine positive ganze Zahl ist.

9. Verfahren nach Anspruch 8, wobei das Auswählen, durch die erste Datenzusammenführungseinheit, eines von einem k-ten Element in dem angepassten ersten zusammenzuführenden Vektor und einem k-ten Element in dem zweiten zusammenzuführenden Vektor als das k-te Element, das dem ersten zusammengeführten Vektor entspricht, umfasst:
Bestimmen, durch die erste Datenzusammenführungseinheit, des k-ten Elements in dem angepassten ersten zusammenzuführenden Vektor als das k-te Element, das dem ersten zusammengeführten Vektor entspricht, in einem Fall, dass das k-te Element in dem angepassten ersten zusammenzuführenden Vektor ein gültiges Element ist;
oder
Bestimmen, durch die erste Datenzusammenführungseinheit, des k-ten Elements in dem zweiten zusammenzuführenden Vektor als das k-te Element, das dem ersten zusammengeführten Vektor entspricht, in einem Fall, dass das k-te Element in dem zweiten zusammenzuführenden Vektor ein gültiges Element ist.

10. Verfahren zum Dekomprimieren von Vektordaten, die durch das Verfahren nach Anspruch 1 erhalten wurden, wobei das Verfahren durch einen Prozessor (900) durchgeführt wird, **dadurch gekennzeichnet, dass** der Prozessor (900) ein Zielvektorregister (901), eine Datenaufteilungsvorrichtung (902) und n Sätze von Multiplexern umfasst, wobei n eine ganze Zahl größer als 1 ist; und
wobei das Verfahren umfasst:
Speichern, durch das Zielvektorregister (901), von Zielvektordaten, wobei gültige Elemente in den Zielvektordaten an einem Kopf der Zielvektordaten angeordnet sind, und wobei ein Element in einem booleschen Vektor, der den Quellvektordaten entspricht, zum Anzeigen einer Verteilung der gültigen Elemente in den Quellvektordaten verwendet wird (1101);
Verschieben und Aufteilen, durch die Datenaufteilungsvorrichtung (902), der Zielvektordaten, um n Ziel-Teilvektoren zu erhalten, wobei gültige Elemente in jedem der Ziel-Teilvektoren an einem Kopf des Ziel-Teilvektors angeordnet sind (1102); und
jeweiliges Dekomprimieren, durch die n Sätze von Multiplexern, der n Ziel-Teilvektoren, um n Quell-Teilvektoren zu erhalten, wobei die n Quell-Teilvektoren konfiguriert sind, kombiniert zu werden, um Quellvektordaten basierend auf dem booleschen Vektor zu erhalten (1103);
wobei die Datenaufteilungsvorrichtung (902) m Sätze von Datenaufteilungseinheiten umfasst, wobei die m Sätze von Datenaufteilungseinheiten konfiguriert sind, p Runden des Verschiebens und Aufteilens an den Zielvektordaten durchzuführen, um die n Ziel-Teilvektoren zu erhalten, wobei m eine ganze Zahl größer als 1 ist, und wobei p eine positive ganze Zahl ist; und
wobei das Verschieben und Aufteilen, durch die Datenaufteilungsvorrichtung (902), der Zielvektordaten, um n Ziel-Teilvektoren zu erhalten, umfasst:
Verschieben und Aufteilen, durch einen q-ten Satz von Datenaufteilungseinheiten in den m Sätzen von Datenaufteilungseinheiten für eine q-te Runde des Verschiebens und Aufteilens, eines q-ten Satzes von aufzuteilenden Vektoren, um einen q-ten Satz von aufgeteilten Vektoren zu erhalten, wobei q eine positive ganze Zahl kleiner oder gleich p ist; und
wobei in einem Fall, dass q gleich 1 ist, der q-te Satz von aufzuteilenden Vektoren die Zielvektordaten ist, und in einem Fall, dass q größer als 1 ist, der q-te Satz von aufzuteilenden Vektoren ein (q-1)-ter Satz von aufgeteilten Vektoren ist, und wobei ein p-ter Satz von aufgeteilten Vektoren die n Ziel-Teilvektoren ist.

11. Verfahren nach Anspruch 10, wobei der q-te Satz von aufgeteilten Vektoren s aufgeteilte Vektoren umfasst, die einem ersten aufzuteilenden Vektor in dem q-ten Satz von aufzuteilenden Vektoren entsprechen, wobei s eine ganze Zahl größer als 1 ist; und
wobei in einem Fall, dass eine erste Datenaufteilungseinheit in dem q-ten Satz von Datenaufteilungseinheiten den ersten aufzuteilenden Vektor verschiebt und aufteilt, die s aufgeteilten Vektoren, die dem ersten aufzuteilenden Vektor entsprechen, auf folgende Weise erhalten werden:
Bestimmen, durch die erste Datenaufteilungseinheit, von s Aufteilungselementanzahlen, die dem ersten aufzuteilenden Vektor entsprechen;
Bestimmen, durch die erste Datenaufteilungseinheit, von s Sätzen von gültigen Aufteilungselementen basierend auf dem booleschen Vektor, der den Zielvektordaten entspricht, und den s Aufteilungselementanzahlen;
jeweiliges Verschieben, durch die erste Datenaufteilungseinheit, der s Sätze von gültigen Aufteilungselementen als Ganzes in dem ersten aufzuteilenden Vektor basierend auf den s Sätzen von gültigen Aufteilungselementen, um einen verschobenen ersten aufzuteilenden Vektor zu erhalten; und
Aufteilen, durch die erste Datenaufteilungseinheit, des verschobenen ersten aufzuteilenden Vektors basierend auf den s Aufteilungselementanzahlen, um s aufgeteilte Vektoren zu erhalten, die dem ersten aufzuteilenden Vektor entsprechen.

12. Verfahren nach Anspruch 11, wobei das jeweilige Verschieben, durch die erste Datenaufteilungseinheit, der s Sätze von gültigen Aufteilungselementen als Ganzes in dem ersten aufzuteilenden Vektor basierend auf den s Sätzen von gültigen Aufteilungselementen, um einen verschobenen ersten aufzuteilenden Vektor zu erhalten, umfasst:
Bestimmen, durch die erste Datenaufteilungseinheit für eine Zielaufteilungselementanzahl in den s Aufteilungselementanzahlen, einer Anzahl von zu verschiebenden Zielbits, die der Zielaufteilungselementanzahl entspricht, basierend auf einer Differenz zwischen einer Position eines gültigen Zielaufteilungselements, das der Zielaufteilungselementanzahl entspricht, in dem ersten aufzuteilenden Vektor und einer Position des Zielaufteilungselements, das der Zielaufteilungselementanzahl entspricht, in dem booleschen Vektor;
Verschieben, durch die erste Datenaufteilungseinheit, von gültigen Aufteilungselementen in dem ersten aufzuteilenden Vektor, die der Zielaufteilungselementanzahl entsprechen, als Ganzes basierend auf der Anzahl von zu verschiebenden Zielbits, die der Zielaufteilungselementanzahl entspricht, um einen ersten aufzuteilenden Zwischenvektor zu erhalten; und
weiteres Verschieben, durch die erste Datenaufteilungseinheit, des ersten aufzuteilenden Zwischenvektors basierend auf Anzahlen von zu verschiebenden Zielbits, die jeweils verbleibenden Aufteilungselementanzahlen entsprechen, um den verschobenen ersten aufzuteilenden Vektor zu erhalten,
wobei das gültige Zielaufteilungselement, das der Zielaufteilungselementanzahl entspricht, das letzte gültige Aufteilungselement ist, das der Zielaufteilungselementanzahl in absteigender Bitreihenfolge entspricht, und wobei das Zielaufteilungselement, das der Zielaufteilungselementanzahl entspricht, das letzte Aufteilungselement ist, das der Zielaufteilungselementanzahl in absteigender Bitreihenfolge entspricht.

13. Verfahren nach Anspruch 11, wobei die s Aufteilungsvektoren einen Zielaufteilungsvektor umfassen, der einer Zielaufteilungselementanzahl in den s Aufteilungselementanzahlen entspricht; und
wobei das Aufteilen, durch die erste Datenaufteilungseinheit, des verschobenen ersten aufzuteilenden Vektors basierend auf den s Aufteilungselementanzahlen, um die s Aufteilungsvektoren zu erhalten, die dem ersten aufzuteilenden Vektor entsprechen, umfasst:
Bestimmen, durch die erste Datenaufteilungseinheit, eines Bereichs, der dem Zielaufteilungsvektor entspricht, der der Zielaufteilungselementanzahl entspricht, in dem booleschen Vektor basierend auf der Zielaufteilungselementanzahl;
Bestimmen, durch die erste Datenaufteilungseinheit, eines Zielbereichs, der dem Zielaufteilungsvektor in dem verschobenen ersten aufzuteilenden Vektor entspricht, basierend auf dem Bereich, der dem Zielaufteilungsvektor in dem booleschen Vektor entspricht; und
Bestimmen, durch die erste Datenaufteilungseinheit, eines Elements in dem Zielbereich als ein Element des Zielaufteilungsvektors.

14. Computervorrichtung, umfassend einen Prozessor und einen Speicher, wobei der Speicher mindestens eine Anweisung, mindestens ein Programm, einen Codesatz oder einen Anweisungssatz speichert, wobei die mindestens eine Anweisung, das mindestens eine Programm, der Codesatz oder der Anweisungssatz durch den Prozessor geladen und ausgeführt wird, um die Computervorrichtung zu veranlassen, das Verfahren zum Komprimieren von Vektordaten nach einem der Ansprüche 1 bis 9 zu implementieren, oder das Verfahren zum Dekomprimieren von Vektordaten nach einem der Ansprüche 10 bis 13 zu implementieren.

15. Nichtflüchtiges computerlesbares Speichermedium, das mindestens eine Anweisung, mindestens ein Programm, einen Codesatz oder einen Anweisungssatz speichert, wobei die mindestens eine Anweisung, das mindestens eine Programm, der Codesatz oder der Anweisungssatz von einem Prozessor geladen und ausgeführt wird, um einen Computer zu veranlassen, das Verfahren zum Komprimieren von Vektordaten nach einem der Ansprüche 1 bis 9 zu implementieren oder das Verfahren zum Dekomprimieren von Vektordaten nach einem der Ansprüche 10 bis 13 zu implementieren.

## Revendications

1. Procédé de compression de données vectorielles, le procédé étant exécuté par un processeur (200), **caractérisé en ce que** le processeur (200) comprend un registre de vecteur source (201), n ensembles de multiplexeurs, un appareil de fusion de données (202), et un registre de vecteur cible (203), n étant un entier supérieur à 1 ; et
le procédé comprenant :
le stockage, par le registre de vecteur source (201), de données de vecteur source, les données de vecteur source étant divisées en n sous-vecteurs sources, les n sous-vecteurs sources étant en correspondance biunivoque avec les n ensembles de multiplexeurs (401) ;
l'agencement sélectif, par un i-ième ensemble de multiplexeurs dans les n ensembles de multiplexeurs, d'éléments valides dans un i-ième sous-vecteur source dans les données de vecteur source, pour obtenir un i-ième sous-vecteur cible correspondant au i-ième sous-vecteur source, les éléments valides dans le i-ième sous-vecteur cible étant situés à un en-tête du i-ième sous-vecteur cible, et i étant un entier positif inférieur ou égal à n, et un élément dans un vecteur booléen correspondant aux données de vecteur source étant utilisé pour indiquer une distribution des éléments valides dans les données de vecteur source (402) ;
le décalage et la fusion, par l'appareil de fusion de données (202), de n sous-vecteurs cibles correspondant aux n sous-vecteurs sources, pour obtenir des données de vecteur cible, les éléments valides dans les données de vecteur cible étant situés à un en-tête des données de vecteur cible (403) ; et
le stockage, par le registre de vecteur cible (203), des éléments valides dans les données de vecteur cible (404).

2. Procédé selon la revendication 1, dans lequel le i-ième sous-vecteur source comprend x éléments, les x éléments comprenant y éléments valides, et le i-ième ensemble de multiplexeurs comprenant x-1 multiplexeurs de types différents, x étant un entier positif, et y étant un entier positif inférieur ou égal à x-1 ; et
l'agencement sélectif, par un i-ième ensemble de multiplexeurs dans les n ensembles de multiplexeurs, d'éléments valides dans un i-ième sous-vecteur source dans les données de vecteur source, pour obtenir un i-ième sous-vecteur cible correspondant au i-ième sous-vecteur source comprend :
la sélection, par y multiplexeurs dans les x-1 multiplexeurs, des y éléments valides parmi les x éléments dans l'ordre croissant des bits sur la base du vecteur booléen correspondant aux données de vecteur source, et l'agencement des y éléments valides dans l'ordre croissant des bits, pour obtenir le i-ième sous-vecteur cible.

3. Procédé selon la revendication 2, dans lequel la sélection, par y multiplexeurs dans les x-1 multiplexeurs, des y éléments valides parmi les x éléments dans l'ordre croissant des bits sur la base d'un vecteur booléen correspondant aux données de vecteur source, et l'agencement des y éléments valides dans l'ordre croissant des bits, pour obtenir le i-ième sous-vecteur cible comprend :
la sélection, par un z-ième multiplexeur dans les y multiplexeurs, d'un z-ième élément valide parmi un z-ième élément à un x-ième élément dans le i-ième sous-vecteur source dans l'ordre croissant des bits sur la base du vecteur booléen, z étant un entier positif inférieur ou égal à y ; et
l'ajout, par le z-ième multiplexeur, du z-ième élément valide à une z-ième position du i-ième sous-vecteur cible.

4. Procédé selon la revendication 1, dans lequel l'appareil de fusion de données (202) comprend m ensembles d'unités de fusion de données, les m ensembles d'unités de fusion de données étant configurés pour effectuer p tours de décalage et de fusion sur les n sous-vecteurs cibles pour obtenir les données de vecteur cible, m étant un entier supérieur à 1, et p étant un entier positif ; et
le décalage et la fusion, par l'appareil de fusion de données (202), de n sous-vecteurs cibles correspondant aux n sous-vecteurs sources, pour obtenir des données de vecteur cible comprennent :
le décalage et la fusion, par un q-ième ensemble d'unités de fusion de données dans les m ensembles d'unités de fusion de données pour un q-ième tour de décalage et de fusion, d'un q-ième ensemble de vecteurs à fusionner, pour obtenir un q-ième ensemble de vecteurs fusionnés, q étant un entier positif inférieur ou égal à p ; et
dans le cas où q est égal à 1, le q-ième ensemble de vecteurs à fusionner étant les n sous-vecteurs cibles, et dans le cas où q est supérieur à 1, le q-ième ensemble de vecteurs à fusionner étant un (q-1)-ième ensemble de vecteurs fusionnés, et un p-ième ensemble de vecteurs fusionnés étant les données de vecteur cible.

5. Procédé selon la revendication 4, dans lequel le décalage et la fusion, par un q-ième ensemble d'unités de fusion de données dans les m ensembles d'unités de fusion de données, d'un q-ième ensemble de vecteurs à fusionner, pour obtenir un q-ième ensemble de vecteurs fusionnés comprennent :
le décalage et la fusion, par les unités de fusion de données dans le q-ième ensemble d'unités de fusion de données, de chaque deux vecteurs à fusionner adjacents dans le q-ième ensemble de vecteurs à fusionner, pour obtenir le q-ième ensemble de vecteurs fusionnés.

6. Procédé selon la revendication 5, dans lequel dans le cas où une première unité de fusion de données dans le q-ième ensemble d'unités de fusion de données décale et fusionne un premier vecteur à fusionner et un deuxième vecteur à fusionner dans le q-ième ensemble de vecteurs à fusionner, le décalage et la fusion, par les unités de fusion de données dans le q-ième ensemble d'unités de fusion de données, de chaque deux vecteurs à fusionner adjacents dans le q-ième ensemble de vecteurs à fusionner, pour obtenir le q-ième ensemble de vecteurs fusionnés comprennent :
le décalage, par la première unité de fusion de données, du premier vecteur à fusionner sur la base du deuxième vecteur à fusionner, pour obtenir un premier vecteur à fusionner ajusté ; et
la fusion, par la première unité de fusion de données, du premier vecteur à fusionner ajusté et du deuxième vecteur à fusionner, pour obtenir un premier vecteur fusionné correspondant au q-ième ensemble de vecteurs fusionnés,
un élément correspondant au deuxième vecteur à fusionner dans les données de vecteur source étant à un bit inférieur à un élément correspondant au premier vecteur à fusionner dans les données de vecteur source.

7. Procédé selon la revendication 6, dans lequel le décalage, par la première unité de fusion de données, du premier vecteur à fusionner sur la base du deuxième vecteur à fusionner, pour obtenir un premier vecteur à fusionner ajusté comprend :
le remplissage, par la première unité de fusion de données, du premier vecteur à fusionner avec des éléments sur la base d'une quantité d'éléments dans le deuxième vecteur à fusionner, pour obtenir un premier vecteur à fusionner rempli, une quantité d'éléments dans le premier vecteur à fusionner rempli étant une somme de la quantité des éléments dans le deuxième vecteur à fusionner et d'une quantité d'éléments dans le premier vecteur à fusionner ; et
le décalage, par la première unité de fusion de données, des éléments de non-remplissage dans le premier vecteur à fusionner rempli dans leur ensemble sur la base d'une quantité d'éléments invalides dans le deuxième vecteur à fusionner, pour obtenir le premier vecteur à fusionner ajusté, une quantité d'éléments de non-remplissage correspondant à un en-tête du premier vecteur à fusionner ajusté étant la même que la quantité des éléments valides dans le deuxième vecteur à fusionner.

8. Procédé selon la revendication 6, dans lequel la fusion, par la première unité de fusion de données, du premier vecteur à fusionner ajusté et du deuxième vecteur à fusionner, pour obtenir un premier vecteur fusionné correspondant au q-ième ensemble de vecteurs fusionnés comprend :
la sélection, par la première unité de fusion de données, d'éléments correspondant au premier vecteur fusionné parmi le premier vecteur à fusionner ajusté et le deuxième vecteur à fusionner dans l'ordre croissant des bits ; et
la sélection, par la première unité de fusion de données pour un k-ième élément correspondant au premier vecteur fusionné, de l'un d'un k-ième élément dans le premier vecteur à fusionner ajusté et d'un k-ième élément dans le deuxième vecteur à fusionner comme le k-ième élément correspondant au premier vecteur fusionné, k étant un entier positif.

9. Procédé selon la revendication 8, dans lequel la sélection, par la première unité de fusion de données, de l'un d'un k-ième élément dans le premier vecteur à fusionner ajusté et d'un k-ième élément dans le deuxième vecteur à fusionner comme le k-ième élément correspondant au premier vecteur fusionné comprend :
la détermination, par la première unité de fusion de données, du k-ième élément dans le premier vecteur à fusionner ajusté comme le k-ième élément correspondant au premier vecteur fusionné dans le cas où le k-ième élément dans le premier vecteur à fusionner ajusté est un élément valide ; ou
la détermination, par la première unité de fusion de données, du k-ième élément dans le deuxième vecteur à fusionner comme le k-ième élément correspondant au premier vecteur fusionné dans le cas où le k-ième élément dans le deuxième vecteur à fusionner est un élément valide.

10. Procédé de décompression de données vectorielles obtenues par le procédé selon la revendication 1, le procédé étant exécuté par un processeur (900), **caractérisé en ce que** le processeur (900) comprend un registre de vecteur cible (901), un appareil de division de données (902), et n ensembles de multiplexeurs, n étant un entier supérieur à 1 ; et
le procédé comprenant :
le stockage, par le registre de vecteur cible (901), de données de vecteur cible, les éléments valides dans les données de vecteur cible étant situés à un en-tête des données de vecteur cible, et un élément dans un vecteur booléen correspondant aux données de vecteur source étant utilisé pour indiquer une distribution des éléments valides dans les données de vecteur source (1101) ;
le décalage et la division, par l'appareil de division de données (902), des données de vecteur cible, pour obtenir n sous-vecteurs cibles, les éléments valides dans chacun des sous-vecteurs cibles étant situés à un en-tête du sous-vecteur cible (1102) ; et
la décompression respective, par les n ensembles de multiplexeurs, des n sous-vecteurs cibles, pour obtenir n sous-vecteurs sources, les n sous-vecteurs sources étant configurés pour être combinés pour obtenir des données de vecteur source sur la base du vecteur booléen (1103) ;
dans lequel l'appareil de division de données (902) comprend m ensembles d'unités de division de données, les m ensembles d'unités de division de données étant configurés pour effectuer p tours de décalage et de division sur les données de vecteur cible pour obtenir les n sous-vecteurs cibles, m étant un entier supérieur à 1, et p étant un entier positif ; et
le décalage et la division, par l'appareil de division de données (902), des données de vecteur cible, pour obtenir n sous-vecteurs cibles comprennent :
le décalage et la division, par un q-ième ensemble d'unités de division de données dans les m ensembles d'unités de division de données pour un q-ième tour de décalage et de division, d'un q-ième ensemble de vecteurs à diviser, pour obtenir un q-ième ensemble de vecteurs divisés, q étant un entier positif inférieur ou égal à p ; et
dans le cas où q est égal à 1, le q-ième ensemble de vecteurs à diviser étant les données de vecteur cible, et dans le cas où q est supérieur à 1, le q-ième ensemble de vecteurs à diviser étant un (q-1)-ième ensemble de vecteurs divisés, et un p-ième ensemble de vecteurs divisés étant les n sous-vecteurs cibles.

11. Procédé selon la revendication 10, dans lequel le q-ième ensemble de vecteurs divisés comprend s vecteurs divisés correspondant à un premier vecteur à diviser dans le q-ième ensemble de vecteurs à diviser, s étant un entier supérieur à 1 ; et
dans le cas où une première unité de division de données dans le q-ième ensemble d'unités de division de données décale et divise le premier vecteur à diviser, les s vecteurs divisés correspondant au premier vecteur à diviser sont obtenus de la manière suivante :
la détermination, par la première unité de division de données, de s quantités d'éléments divisés correspondant au premier vecteur à diviser ;
la détermination, par la première unité de division de données, de s ensembles d'éléments divisés valides sur la base du vecteur booléen correspondant aux données de vecteur cible et des s quantités d'éléments divisés ;
le décalage respectif, par la première unité de division de données, des s ensembles d'éléments divisés valides dans leur ensemble dans le premier vecteur à diviser sur la base des s ensembles d'éléments divisés valides, pour obtenir un premier vecteur à diviser décalé ; et
la division, par la première unité de division de données, du premier vecteur à diviser décalé sur la base des s quantités d'éléments divisés, pour obtenir s vecteurs divisés correspondant au premier vecteur à diviser.

12. Procédé selon la revendication 11, dans lequel le décalage respectif, par la première unité de division de données, des s ensembles d'éléments divisés valides dans leur ensemble dans le premier vecteur à diviser sur la base des s ensembles d'éléments divisés valides, pour obtenir un premier vecteur à diviser décalé comprend :
la détermination, par la première unité de division de données pour une quantité d'éléments divisés cible dans les s quantités d'éléments divisés, d'une quantité de bits cibles à décaler correspondant à la quantité d'éléments divisés cible sur la base d'une différence entre une position d'un élément divisé valide cible correspondant à la quantité d'éléments divisés cible dans le premier vecteur à diviser et une position de l'élément divisé cible correspondant à la quantité d'éléments divisés cible dans le vecteur booléen ;
le décalage, par la première unité de division de données, des éléments divisés valides dans le premier vecteur à diviser correspondant à la quantité d'éléments divisés cible dans leur ensemble sur la base de la quantité de bits cibles à décaler correspondant à la quantité d'éléments divisés cible, pour obtenir un premier vecteur à diviser intermédiaire ; et le décalage supplémentaire, par la première unité de division de données, du premier vecteur à diviser intermédiaire sur la base des quantités de bits cibles à décaler correspondant respectivement aux quantités d'éléments divisés restantes, pour obtenir le premier vecteur à diviser décalé,
l'élément divisé valide cible correspondant à la quantité d'éléments divisés cible étant le dernier élément divisé valide correspondant à la quantité d'éléments divisés cible dans l'ordre décroissant des bits, et l'élément divisé cible correspondant à la quantité d'éléments divisés cible étant le dernier élément divisé correspondant à la quantité d'éléments divisés cible dans l'ordre décroissant des bits.

13. Procédé selon la revendication 11, dans lequel les s vecteurs divisés comprennent un vecteur divisé cible correspondant à une quantité d'éléments divisés cible dans les s quantités d'éléments divisés ; et
la division, par la première unité de division de données, du premier vecteur à diviser décalé sur la base des s quantités d'éléments divisés, pour obtenir les s vecteurs divisés correspondant au premier vecteur à diviser comprend :
la détermination, par la première unité de division de données, d'une région correspondant au vecteur divisé cible correspondant à la quantité d'éléments divisés cible dans le vecteur booléen sur la base de la quantité d'éléments divisés cible ;
la détermination, par la première unité de division de données, d'une région cible correspondant au vecteur divisé cible dans le premier vecteur à diviser décalé sur la base de la région correspondant au vecteur divisé cible dans le vecteur booléen ; et
la détermination, par la première unité de division de données, d'un élément dans la région cible comme un élément du vecteur divisé cible.

14. Dispositif informatique, comprenant un processeur et une mémoire, la mémoire stockant au moins une instruction, au moins un programme, un ensemble de codes, ou un jeu d'instructions, ladite au moins une instruction, ledit au moins un programme, ledit ensemble de codes, ou ledit jeu d'instructions étant chargé et exécuté par le processeur pour amener le dispositif informatique à mettre en œuvre le procédé de compression de données vectorielles selon l'une quelconque des revendications 1 à 9, ou mettre en œuvre le procédé de décompression de données vectorielles selon l'une quelconque des revendications 10 à 13.

15. Support de stockage non volatil lisible par ordinateur, stockant au moins une instruction, au moins un programme, un ensemble de codes ou un jeu d'instructions, ladite au moins une instruction, ledit au moins un programme, ledit ensemble de codes ou ledit jeu d'instructions étant chargé et exécuté par un processeur pour amener un ordinateur à mettre en œuvre le procédé de compression de données vectorielles selon l'une quelconque des revendications 1 à 9 ou à mettre en œuvre le procédé de décompression de données vectorielles selon l'une quelconque des revendications 10 à 13.
